(19) Europäisches Patentamt
European Patent Office
Office européen des brevets

(11) EP 1 799 024 B1

(12) # EUROPEAN PATENT SPECIFICATION

(45) Date of publication and mention of the grant of the patent:
**17.11.2010 Bulletin 2010/46**

(51) Int Cl.:
***H05K 13/04*** *(2006.01)*

(21) Application number: **07103732.9**

(22) Date of filing: **07.12.2000**

(54) **Part mounting method, part mounting device, and recording media**

Bauteilbestückungsmethode und Vorrichtung und Aufzeichnungsmedium

Procédé et dispositif pour le montage de pièces et supports d'enregistrement

(84) Designated Contracting States:
**DE GB**

(30) Priority: **07.12.1999 JP 34756599**
**31.03.2000 JP 2000097965**

(43) Date of publication of application:
**20.06.2007 Bulletin 2007/25**

(62) Document number(s) of the earlier application(s) in accordance with Art. 76 EPC:
**00979954.5 / 1 248 509**

(73) Proprietor: **Panasonic Corporation**
**Kadoma-shi**
**Osaka 571-8501 (JP)**

(72) Inventors:
- **Yamamoto, Hiroki**
**Yamanashi 400-0062 (JP)**
- **Imafuku, Shigeki,**
**Matsushita Electric Industrial Co., LTd.**
**Chuo-ku,**
**Osaka-shi,**
**Osaka 540-6319 (JP)**
- **Izumida, Keizo**
**Arlington Heights, IL 60005 (US)**
- **Kuribayashi, Takeshi**
**Yamanashi 409-3822 (JP)**

(74) Representative: **Eisenführ, Speiser & Partner**
**Postfach 10 60 78**
**28060 Bremen (DE)**

(56) References cited:
**EP-A- 0 306 653** **EP-A2- 0 891 129**
**JP-A- 2000 286 600**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

**Description**

**BACKGROUND OF THE INVENTION**

The present invention relates to a method for mounting components, such as electronic components, onto a circuit substrate, such as an electronic circuit board, as well as an apparatus for mounting components which is capable of performing such a method. The present invention also relates to a computer readable storage medium for carrying out such a method.

In the field of component mounting for mounting components, such as electronic components, on a circuit substrate, such as an electronic circuit board, a plurality of supplying devices carrying numbers of components are attached to a component mounting apparatus, and the components are picked up one after another from these supplying devices in a predetermined order. Each component is then detected whether it is held by a component holder in a proper condition for mounting. If it is determined that the component is held in proper condition, a displacement amount between the component and the component holder is measured. After necessary position correction is made based on the measured displacement, the component is mounted on a predetermined position of a circuit substrate. If it is determined that the component is held in improper condition for mounting, or the component is held in a position where proper imaging may not be preformed by a imaging device, the component holder does not mount such a component on a circuit substrate, but rather releases the component at a predetermined station.

The term "circuit substrate" used hereinafter means a material on which electronic components may be mounted. An electronic circuit board is a typical example of the circuit substrate. In these days, however, there are some cases where components are mounted on other types of materials, such as a casing of an electronic equipment. Therefore, the term "circuit substrate" used in this specification includes any other types of materials where components may be mounted.

Based on a market demand for smaller and lighter electronic devices in recent years, density of components mounted on a circuit substrate has become higher, and hence a space between the components mounted adjacently becomes narrower, and size of component itself becomes smaller. For the purpose avoiding any damages to the adjacent components already mounted on a circuit substrate, more severe control of holding condition of a component by the component holder is required. Further, a tip of a nozzle, or the component holder, for sucking a component tends to be designed as small as possible so as not to interfere with the component already mounted, when the nozzle approaches the circuit substrate for mounting a subsequent component.

A conventional component mounting apparatus is now described by referring to Figs. 5 to 7. Fig 5 shows an overall view of the component mounting apparatus. Referring to Fig. 5, the component mounting apparatus includes a main body 1 and a component supply 2. A series of component mounting operations are being performed inside the main body 1, which includes picking up a component supplied to the component supply 2, and mounting the component onto a circuit substrate supplied from one side of the main body 1.

Figs. 6(A) and 6(B) show perspective view of a reel carrying numbers of components, and a cassette or a supplying device, respectively, used for supplying components to the component supply 2. In Fig 6(a), numbers of components 3 are contained in a tape 4 by having a definite space 5 between each other, and the tape 4 is wound on a reel 6. The reel 6 is then rotatably attached to the component supply device, or a cassette 7 as shown in Fig. 6(b). The cassette 7 moves forward the tape 4 intermittently for a distance equivalent to the space 5 so that the component 3 is being placed at a component pick up window 9 one after another. Normally, a plurality of cassettes 7 are attached to the component supply 2 of the component mounting apparatus, as seen in Fig. 5. The component supply 2 is driven back and forth in X direction shown in Fig. 5 by a motor, so that the cassette 7 carrying the components to be picked up may be positioned at the predetermined picking up station. Although cassette type of the component supply device is illustrated in Figs. 6(a) and 6(b), some other types, such as a bulk feeder type to supply components using compressed air, or a tray type to supply components by arranging components on a flat tray, may be used.

Fig. 7 schematically shows a series of component mounting operations, from picking up a component to mounting the same on the circuit substrate, all of which are performed inside the main body 1 of the component mounting apparatus shown in Fig. 5. The cassette 7, or a supplying device, is attached to the component supply 2 at right hand side of Y direction of Fig. 7. As described above, a component 3 is supplied one by one from the reel 6 attached to the cassette 7 to the pick up window 9 by an operation of a lever 8. On the other side of Y direction of the drawing, an element 10 is located inside the main body 1. As a main portion of the element 10, an index 11 holds a plurality of placement heads 12 on its circumference, which are used for mounting components on a circuit substrate. As the index 11 is rotated intermittently to a direction shown by an arrow 13 by means of a motor, each placement head 12 is rotated and shifted its position sequentially. A nozzle 14, or a component holder, is capable of moving up and down in Z direction of the drawing, and is capable of rotating around a center axis parallel to Z axis of the drawing, each of which is driven by a motor. Piping is connected to each nozzle to supply vacuum and compressed air for sucking and releasing a component. A circuit substrate 21 is supplied to the main body 1 by a feeder, and held firmly by a circuit substrate holder, not shown in the drawing, and is capable of moving both in X and Y directions of the drawing by means of motors.

Again referring to Fig. 7, a nozzle 14 positioned at pick up station 15 sucks a component 3 from the pick up window 9 of the cassette 7 by means of vacuum. The nozzle 14 then moves to next detecting station 16 by the next intermittent rotation of the index 11, where holding condition of the component 3 is detected by a condition sensor 17. When the index 11 rotates further, the nozzle 14 moves to the next imaging station 18, where sucking point of the component 3 is recognized by an imaging device 19. With a further intermittent rotation of the index 11, the nozzle 14 moved to mounting station 20 where the nozzle 14 moves down in Z direction of the drawing, and mounts the component 13 on the predetermined mounting position of the circuit substrate 21. The circuit substrate 21 may be moved by the circuit substrate holder in both X and Y directions in accordance with predetermined mounting position data (by means of NC program).

When the condition sensor 17 determines that the component 3 is not in proper condition for mounting, the nozzle 14 does not mount such a component 3 at mounting station 20, but rather, releases it into a collecting box 23 when the nozzle 14 moves to the next releasing station 22. Each of the plurality of nozzles 14 attached to each placement head 12 performs operations of sucking, mounting, and, if necessary, releasing the component 13 synchronously in accordance with intermittent rotation of the index 11. Reference numerals 25 and 26 in Fig. 7 are a controller for determining component holding condition, and a controller for recognizing component sucking point and measuring displacement, respectively. In Fig. 7, components 3 shown at and after the detecting station 16 are illustrated in somewhat oversized for the purpose of easier understanding.

Next, an outline of a method for determining holding condition of the component is described by referring to Fig. 8. Holding condition of the component 3 sucked by the nozzle 14 is detected, for example, by a line sensor 17 projecting beams from a projection side 28 toward a receiving side 29. As shown in the drawing, if height of the component 3 held by the nozzle 14 falls within a predetermined allowance Δh compared to a targeted height h1 (h1 = nozzle height h2 - thickness of the component 3), in other word, if the relation

$$(h1 - \Delta h) < h1 < (h1 + \Delta h)$$

is satisfied, it is determined that the nozzle 14 holds the correct component 3 intended to pick up, and that the component 3 is in proper condition for mounting. On the contrary, if the detected height h3 satisfies the relation,

$$h3 < (h1 - \Delta h)$$

it is determined that the component 3 is not in proper condition for mounting (hereinafter, referred to as "improperly held condition"). If it is determined that the component 3 is in improperly held condition, that particular component 3 would not be mounted at mounting station 20 of Fig. 7, but rather, the component 3 is released into the collecting box 23 at the releasing station 22. If the nozzle 14 sucks a false component, or a component which is not intended to pick up, such a false component is detected in a similar manner, and such a false component is also released into the collecting box 23 at the releasing station 22.

Fig. 9 shows a method for measuring a displacement value between a sucking point 31 of the component 3 and the position of the nozzle 14, which is performed at imaging station 18. In the drawing, a rectangle in solid lines shows a configuration of a sucked component 3, while a dotted circular line shows the nozzle 14 sucking the component 3. Targeted sucking point of the component 3 may be predetermined based on, for example, the configuration or the center of gravity of the component 3. To make understanding easier, the targeted sucking point in the drawing is located at the center 31 of the component 3. The sucking point of the nozzle 14 may also be predetermined nozzle by nozzle basis, but in this case, too, the point is located at the center 32 of the nozzle 14 for easier understanding. The imaging device 19 provided at the imaging station 18 of the index 11 rotation shown in Fig. 7 images the component 3 sucked by the nozzle 14 from its bottom, and recognizes the center 31 of the component 3 as shown in Fig. 9. Since the center position 32 of the nozzle 14 is previously known, displacement values in X direction (Δx) and Y direction (Δy) between the center 32 of the nozzle 14 and the center 31 of the component 3 are measured, whereby a total displacement value Δa may be measured.

Tilt angle of the component 3 held by the nozzle 14 is also recognized at imaging station 18. For example, if the component 3 is tilted against X and Y axes of the drawing, such tilt angle $\alpha$ may be recognized by the imaging device 19.

The operations of the conventional component mounting apparatus are now described by referring to Fig. 10. When production operations are started at step #901, a circuit substrate 21 is transported into the apparatus and firmly held by the circuit substrate holder at step #902. Also, a component 3 is picked up from the component supply 2 at step #903. At step #904, holding condition of the component 3 is detected by the condition sensor 17 at the detecting station 16, and the controller for determining component holding condition 25 determines whether the component is held in proper condition or not, based on the detection. If it is determined that the holding condition of the component 3 is within an allowable range for mounting, the work flow goes to step #905 where the center 31 of the component 3, or a targeted sucking point is recognized, and then the displacement value $\Delta a$ (see Fig. 9) between the center 31 of the component 3 and the center 32 of the nozzle 14, or a targeted point of the nozzle 14, is measured. Further, the tilt angle $\alpha$ (see Fig. 9) of the component 3 is also recognized. If these measurements are made properly at step #906, necessary correction to position and/or angle of the component 3 is made based on the measured displacement value $\Delta a$ and the tilt angle $\alpha$. After the circuit substrate 21 is positioned at a proper place of the mounting station 20 at step #907, the component 3 is mounted on it at step #908. Then at step #909, it is checked whether this component is the last one to be mounted on that particular circuit substrate or not, in other word, it is checked whether all the necessary components 3 are already mounted on that circuit substrate 21 or not. If it is confirmed that all the component were mounted, then, at step #910, it is checked whether this circuit substrate 21 is the final one of the current production lot or not, and if it is confirmed that the circuit substrate 21 is the final one, the production operations are completed after the circuit substrate 21 is pulled out from the apparatus at step #911.

If it is determined at detecting operation at step #904 that no component is sucked, mounting operation is skipped at mounting station 20, and a new component is picked up at step #903 at the next round of the index 11 rotation. If it is determined at the component detecting process at step #904 that the component 3 is in improperly held condition, or the component is a false one, such a component 3 is released into the collecting box 23 at releasing station 22 at step #912, and a new component is picked up at step #903 at the next round of the index 11 rotation.

If it is determined, at step #909, that the component 3 just mounted is not the last one to be mounted, or there are still other component(s) to be mounted on the same circuit substrate, the work flow goes back to step #903 for performing subsequent pick up and mounting operations. If it is determined, at step #910, that the circuit substrate is not the final one for the current production lot, the circuit substrate with mounted components is pulled out from the apparatus, and a new circuit substrate 21 is fed into the apparatus at step #902. All these operations are repeated until all the necessary production operations are completed.

## SUMMARY OF THE INVENTION

Conventional part mounting operations as described above has some drawbacks. Because of recent trend of miniaturization of components, as well as increasing of density of mounted components on a single circuit substrate, a tip surface of a sucking nozzle has become smaller, and this makes it more difficult to confirm whether any debris exists on the tip of the nozzle before component pick up operation is started, or to confirm whether the component is securely released after it is determined that the component is in improperly held condition. In the conventional operations, surface condition of the nozzle tip after the nozzle has released a component may not be checked satisfactorily. Adding a new detecting device, such as a sensor, to the apparatus for the purpose of this checking is also difficult from the view points of space and cost.

If the nozzle fails to release a component, such a remaining component, or a debris, may interfere with a new component when the nozzle approaches the new component to pick up. This may damages both of the components, or in the extreme case, the nozzle itself as well. Moreover, if a small portion of the component, or a debris, remains at the tip of the nozzle, vacuum power for sucking a component may be lowered, and hence, the component may not be sucked and held in proper condition, and may cause a problem for mounting operations.

Furthermore, if the nozzle fails to release a component at releasing station 22, and such a component remains at the tip of the nozzle in unstable condition for the sake of improper sucking operation, the component may fall on the circuit substrate when the component is transported by the nozzle. This may cause damages to other components already mounted on the circuit substrate, or may cause damages to other nozzles when they perform mounting operations.

The description made above is related to a nozzle type component mounting, which utilizes compressed air or vacuum for sucking or releasing components, respectively. There are some other types of component mounting which use a mechanical means, such as a chuck. For these other types of mounting, too, it is a problem if the component, held in improper condition, is not securely released at the releasing station 22.

The present invention, therefore, is made to solve the above mentioned drawbacks, and to provide a method and an apparatus for component mounting which can reliably confirm that the component is securely released from the nozzle after it is determined that the component is, for example, in improperly held condition. The present invention also provides a method and an apparatus for component mounting which can reliably release a component into a predetermined collecting box.

According to the method and the apparatus of component mounting of the present invention, the aforementioned drawbacks may be solved in a manner such that, after the component holder has released a component and before the same component holder picks up a new component, the component holder is subjected to checking whether any debris exists at the tip of the component holder. More specifically, the present invention includes the followings.

One aspect of the present invention relates to a method of component mounting performing series of production operations including steps of: picking up a component supplied to a component supply by a component holder; detecting holding condition of the component held by the component holder; mounting the component on a mounting position of a circuit substrate by the component holder if it is determined at said detecting step that the component is held in proper condition for mounting; and releasing the component at a releasing station instead of mounting it if it is determined at said detecting step that the component is held in improper condition for mounting, and then picking up a new component by the component holder,

wherein the method further includes a step of confirming, prior to said step of picking up a new component, whether any debris exists at the component holder after said component holder has released the component held in improper condition. This is for avoiding any possible negative impacts on component mounting operations caused by any debris remaining at the component holder after the component holder has released a component held in improper condition.

Another aspect of the present invention relates to a method of component mounting performing series of production operations including steps of: picking up a component supplied to a component supply by a component holder; detecting holding condition of the component held by the component holder; mounting the component on a mounting position of a circuit substrate by the component holder if it is determined at said detecting step that the component is held in proper condition for mounting; and releasing the component at a releasing station instead of mounting it if it is determined at said detecting step that the component is held in improper condition for mounting, and then picking up a new component with the component holder, wherein the method further includes a step of checking whether any debris exists at the component holder immediately after production operations are started, and before the component holder picks up a first component. This is for avoiding any possible negative impacts on component mounting operations by checking the component holder immediately after production operations are started.

Another aspect of the present invention relates to a method, wherein, when debris is found at the step of checking or confirming whether any debris exists at the component holder, the method further includes a step of reconfirming whether any debris exists at the component holder (14) immediately after production operations are restarted upon removal of the debris from said component holder, and prior to the step of picking up a new component by said component holder. This is for avoiding any possible negative impact on component mounting operations by reconfirming that debris is removed.

Another aspect of the present invention relates to a method wherein the step of checking, confirming or reconfirming whether any debris exists at the component holder is performed by either one of the detecting devices used for detecting component holding condition.

Another aspect of the present invention relates to a method of component mounting performing series of production operations including steps of: picking up a component supplied to a component supply by a component holder; detecting holding condition of the component held by the component holder; mounting the component on a mounting position of a circuit substrate by the component holder if it is determined at said detecting step that the component is held in proper condition for mounting; and releasing the component at a releasing station instead of mounting it if it is determined at said detecting step that the component is held in improper condition for mounting, and then picking up a new component by the component holder,

wherein, if a displacement value between the component and the component holder is out of a predetermined allowable range, it is determined that the component is held in improper condition for mounting. This is to avoid any possible interference between the component already mounted on the circuit substrate and the component holder, by predetermining allowable range of the above displacement.

Still another aspect of the present invention relates to a method of component mounting performing series of production operations including steps of: picking up a component supplied to a component supply by a component holder; detecting holding condition of the component held by the component holder; mounting the component on a mounting position of a circuit substrate by the component holder if it is determined at said detecting step that the component is held in proper condition for mounting; and releasing the component at a releasing station instead of mounting it if it is determined at said detecting step that the component is held in improper condition for mounting, and then picking up a new component by the component holder,

wherein moving speed of the component holder until it reaches releasing station for releasing the component is decelerated if it is determined at said step of detecting component holding condition that the component is held in improper condition for mounting. This is to avoid falling of the component from the component holder when it is held in improper condition.

Still another aspect of the present invention relates to a method of component mounting performing series of production operations including steps of: picking up a component supplied to a component supply by a component holder; detecting holding condition of the component held by the component holder; mounting the component on a mounting position of a circuit substrate by the component holder if it is determined at said detecting step that the component is held in proper condition for mounting; and releasing the component at a releasing station instead of mounting it if it is determined at said detecting step that the component is held in improper condition for mounting, and then picking up a new component by the component holder,

wherein the method further includes steps of: confirming, prior to picking up a new component by the component holder, whether any debris exists at the component holder after said component holder has released a component held in improper condition for mounting; picking up a new component by the component holder if it is confirmed that no debris is found at said step of confirming whether any debris exists; stopping production operations if debris is found at said step of confirming whether any debris exists; and picking up a new component by the component holder after the production operations are restarted upon removal of the debris from the component holder where debris was found. This is for avoiding any possible negative impacts on component mounting operations by reconfirming that debris is removed from the component holder after the component holder has released the component held in improper condition.

Another aspect of the present invention relates to a method of component mounting performing series of production operations including steps of: picking up a component supplied to a component supply by a component holder; detecting holding condition of the component held by the component holder; mounting the component on a mounting position of a circuit substrate by the component holder if it is determined at said detecting step that the component is held in proper condition for mounting; and releasing the component at a releasing station instead of mounting it if it is determined at said detecting step that the component is held in improper condition for mounting, and then picking up a new component by the component holder,

wherein the method further includes steps of: checking whether any debris exists at the component holder immediately after production operations are started and before a first component is picked up; picking up the first component if no debris is found at said step of checking whether any debris exists immediately after production operation are started; stopping production operations if debris is found at said step of checking whether any debris exists immediately after production operation are started; picking up a new component by the component holder after the production operations are restarted upon removal of the debris from the component holder where debris was found. This is for avoiding any possible negative impact on component mounting operations by checking whether any debris remains at the component holder immediately after production operations are started.

Still another aspect of the present invention relates to a method of component mounting performing series of production operations including steps of: picking up a component supplied to a component supply by a component holder; detecting holding condition of the component held by the component holder; mounting the component on a mounting position of a circuit substrate by the component holder if it is determined at said detecting step that the component is held in proper condition for mounting; and releasing the component at a releasing station instead of mounting it if it is determined at said detecting step that the component is held in improper condition for mounting, and then picking up a new component by the component holder,

wherein the method further includes steps of: comparing a displacement value between the component and the component holder with a predetermined allowable range of displacement, prior to detecting holding condition of the component;

correcting position of the component based on the displacement, and mounting the component on the mounting position of the circuit substrate, if the displacement between the component and the component holder falls within said allowable range of the displacement; and releasing the component at releasing station, instead of mounting the component on the circuit substrate, if the displacement between the component and the component holder is out of the allowable range of the displacement. This is for improving density of components mounted on a circuit substrate by predetermining allowable range of the above displacement.

Another aspect of the present invention relates to a component mounting apparatus comprising: a supplying device for supplying components to a component supply; a placement head for picking up the component from the component supply, and mounting the component on a circuit substrate which is positioned and firmly held; a detecting device for detecting holding condition of the component held by a component holder attached to the component placement head; a collecting box for collecting components if it is determined by the detecting device that the components are held in improper condition for mounting: and a transferring device for transferring the placement head to at least stations of picking up components, detecting component holding condition, mounting the component on the circuit substrate, and collecting components, wherein the component mounting apparatus has a controller which controls the production operations so as to perform a confirming operation for confirming any debris exists at the component holder of the placement head by mean of the detecting device, after the placement head has released the component held in improper condition for mounting and before the placement head picks up a new component.

Still another aspect of the present invention relates to a component mounting apparatus comprising: a supplying device for supplying components to a component supply; a placement head for picking up the component from the component supply, and mounting the component on a circuit substrate which is positioned and firmly held; a detecting device for detecting holding condition of the component held by a component holder attached to the component placement head; a collecting box for collecting components if it is determined by the detecting device that the components are held in improper condition for mounting; and a transferring device for transferring the placement head to at least stations of picking up components, detecting component holding condition, mounting the component on the circuit substrate, and collecting components, wherein the component mounting apparatus has a controller which controls the production operations so as to perform a checking operation whether any debris exists at the component holder of the placement head by means of the detecting device, immediately after production operations are started and before the placement head picks up a first component. This is to avoid any possible negative impacts on component mounting operation, by checking whether any debris remains on the component holder immediately after production operations are started.

Another aspect of the present invention relates to a component mounting apparatus, wherein the detecting device recognizes a displacement value between the component and the component holder, and determines that the component is held in improper condition for mounting if said displacement is out of a predetermined allowable range of displacement. This is for improving density of component mounted on a circuit substrate by predetermining allowable range of the above displacement.

Another aspect of the present invention relates to a component mounting apparatus further comprises a debris removing device for removing debris from the component holder, which debris removing device cleans the component holder and removes debris from it in case debris is found at the checking or confirming operation whether any debris exists at the component holder, and/or in case the component holder has released the component held in improper condition for mounting into the collecting box. The above debris removing device comprises any one of an air nozzle to blow off compressed air toward the component holder, a vacuum suction nozzle to cause suction effect in the vicinity of the component holder, a brush like material to clean the component holder, or any combination thereof.

Yet another aspect of the present invention relates to a component mounting apparatus comprising: a supplying device for supplying components to a component supply; a placement head for picking up the component from the component supply, and mounting the component on a circuit substrate which is positioned and firmly held; a detecting device for detecting holding condition of the component held by a component holder attached to the component placement head; a collecting box for collecting components if it is determined by the detecting device that the components are held in improper condition for mounting; and a transferring device for transferring the placement head to at least stations of picking up components, detecting component holding condition, mounting the component on the circuit substrate, and collecting components, wherein the component mounting apparatus has a controller which decelerates moving speed of the placement head equipped with the component holder until the component holder releases the component held in improper condition for mounting into the collecting box. This is to avoid possible falling of the component from the component holder when it is held in improper condition.

Another aspect of the present invention relates to a computer readable storage medium storing a program for performing operations including steps of: picking up a component from a component supply by a component holder; checking the component whether it is held by the component holder in proper condition for mounting; measuring a displacement between the component holder and a sucking point of the component, making necessary correction of position based on the measurement, and then mounting the component on a circuit substrate if it is determined that the component is held in proper condition for mounting at said checking step; releasing the component into a collecting box, instead of mounting it on the circuit substrate if it is determined that the component is held in improper condition for mounting; confirming whether any debris exists at the component holder which has released the component held in improper condition into the collecting box; picking up a new component by the component holder if no debris is found at said confirming step; stopping production operations if debris is found at said confirming step; picking up a new component to be mounted next by the component holder, after the production operations are restarted upon removal of the debris from the component holder where such debris was found. This is for controlling, by using a computer, the operation steps of performing debris removal from the component holder disclosed in the present invention.

The above mentioned computer readable storage medium may store a program performing further operations including steps of: checking whether any debris exists at the component holder immediately after production operations are started and before the component holder picks up a first component from component supply; picking up a first component by the component holder if no debris is found at said checking step; stopping production operations if debris is found at said checking step; and picking up a component by the component holder, after the production operations are restarted upon removal of the debris from the component holder where such debris was found. Alternatively or additionally, the above mentioned computer readable storage medium may store a program performing further operations including steps of: reconfirming whether any debris exists at the component holder immediately after production operations are restarted and before the component holder picks up a new component; picking up a new component with the component holder if no debris is found at said reconfirming step; and stopping production operations if debris is found at said reconfirming step.

## BRIEF DESCRIPTION OF THE DRAWINGS

Fig. 1 shows a flowchart illustrating one embodiment of a method of component mounting according to the present invention;

Fig. 2 shows a flowchart illustrating another embodiment of a method of component mounting according to the present invention;

Fig. 3 shows a flowchart illustrating still another embodiment of a method of component mounting according to the present invention;

Fig. 4 shows a block diagram illustrating one embodiment of a component mounting apparatus according to the present invention;

Fig. 5 is a perspective view of a conventional component mounting apparatus;

Fig. 6(a) shows a reel carrying a tape wound thereon for component mounting according to prior art.

Fig. 6(b) shows a cassette for supplying components to a part mounting apparatus according to prior art.

Fig. 7 shows main operating elements located inside of a main body of a component mounting apparatus according to prior art;

Fig. 8 shows a method of determining a condition of a component held by a component holder according to prior art;

Fig. 9 shows a method of measuring a displacement of a component according to prior art;

Fig. 10 is a flow chart illustrating a method of component mounting according to prior art, and

Figs. 11(a) to 11(c) show examples of debris removing device of still another embodiment of the present invention.

## DETAILED DESCRIPTION OF THE PREFERRED EMBODIMENTS

The present invention will now be described in more detail by referring to the appended drawings. In the following description, rotary type component mounting apparatus is used as an example. The rotary type component mounting apparatus has a plurality of placement heads deployed circumferentially around an index which rotates intermittently during operations. Application of the present invention, however, is not limited to this type of component mounting apparatus. The present invention may alternatively be applied to any other types of component mounting apparatus, such as a XY robot type, in which component placement heads are moved both in X and Y directions for picking up and mounting a component.

Further, in the following description, a nozzle type component holder is used as an example. A nozzle picks up a component and mounts it on the circuit substrate by using vacuum and compressed air. The present invention, however, may be applied to any other types of component holders, such as a chuck type which mechanically picks up and mounts a component. Again, in the following description, a circuit substrate is used as an example of materials onto which components are mounted. The present invention, however, may be applied to other types of materials, such as a component itself, or a electronic device case onto which components may be mounted directly.

Fig. 1 shows a flow chart of a method of component mounting according to the 1st embodiment of the present invention. Structures of the main body of the component mounting apparatus performing the method of the present embodiment are similar to those of the prior art described above by referring to Fig. 7. According to the method of the present embodiment, a nozzle which has released a component held in improper condition is subjected to confirming whether any debris remains and exists at the tip of the nozzle. That particular nozzle is allowed to pick up a new component only if it is confirmed that no debris remains at its tip.

In the method of component mounting according to the present embodiment shown in Fig.1, after production operations are started at step #101, a circuit substrate 21 is fed into the apparatus and firmly held by the circuit substrate holder at step #102, and a component 3 is picked up from a component supply 2 at step #103. Then, at step #104, holding condition of the component 3 is detected by the condition sensor 17. If it is determined that the component 3 is held in proper condition for mounting, the work flow goes to step #105 where the sucking point of the component is recognized at the imaging station. If it is confirmed that the sucking point is properly recognized, a displacement value $\Delta a$ (see Fig. 9) between the sucking point 31 and the nozzle 14, as well as tilt angle $\alpha$ are measured. In this context, both determining holding condition, and recognizing holding point and measuring the displacement are included in "detecting holding condition". After necessary correction of position and/or tilt angle is made, the work flow goes to step #107 for positioning a circuit substrate 21 at the mounting station, and then the component 3 is mounted on the circuit substrate at step #108. In step #109, it is checked whether the component just mounted is the last one to be mounted on that particular circuit substrate 21 or not, and if it is confirmed that the component is the last one, the work flow goes to #110 where it is checked whether the circuit substrate is the final one for the production lot or not. If it is confirmed that the circuit substrate is the final one, the circuit substrate 21 is pulled out from the apparatus, and production operations are completed.

When it is found that no component is picked up at holding condition detecting process at step #104, mounting operation is skipped at the next mounting station 20, and work flow goes back to step #103 where a new component is sucked and picked up at pick up station 15 at the next round of the index 11 rotation. And if it is determined at the holding condition detecting process at step #104 that the component is in improperly held condition, or the sucked component is a false one, the work flow goes to step #112 where sucking is terminated at releasing station 22 for releasing the component into the collecting box 23. In such a case, a new component 3 is not picked up at pick up station 15 at the next round of the index 11 rotation, and instead, the tip of the nozzle 14 is subjected to confirming whether any debris remains on the nozzle 14 by using the condition sensor 17 at detecting station 16 at step #114. At step #115, if it is confirmed that no debris remains at the tip of the nozzle 14, the work flow goes back to step #103, and the nozzle 14 sucks a new component 3 for picking up.

At step #115, if any debris is found at the tip of the nozzle, production operations of the component mounting apparatus are stopped at step #116, and/or warning, such as displaying error message or making an alarm, is generated so as to inform the problem to an operator. At step #117, the operator checks the tip of the nozzle 14 where the debris was found, and takes necessary maintenance work for removing them. The operator then turn of the power of the apparatus to restart production operations after confirming that no debris remains any more. When production operations are restarted, component releasing operation is performed one more time at step #112, and component pick up operation is skipped at the next round pick up station 15 as shown by step #113, and then, it is reconfirmed whether any debris remains at the nozzle tip at step #114. The above mentioned operations are repeated depending upon the results of the reconfirmation process of the nozzle tip condition at step #115.

In case of rotary type component mounting apparatus, the order of the operations performed by nozzles, which are deployed around the circumference of the index 11, is predetermined in association with rotation of the index 11. Therefore, component pick up operation at the next round of pick up station 15 needs to be skipped as shown by step #113, and possible existence of debris at the tip of the nozzle 14 needs to be checked first at detecting station 16 at step #114. Component pick up operation is started at the next round of the index 11 rotation when the nozzle approaches to the pick up station 15. In case of XY robot type component mounting apparatus, on the contrary, it is possible, by modifying the system logic, to first move the nozzle toward detecting station 16 directly for confirming any debris remains, and then move the nozzle to the component pick up station 15.

In the present embodiment, after the operator checks the nozzle condition at step #117, the flow goes back to step #112 and skipping component pick up operation by this particular nozzle 14 at step #113. A new component may be sucked only after reconfirming no debris remains at the nozzle by the condition sensor 17 at step #114. The reason for this is to avoid any possible failure at the confirmation process conducted by the operator. Since the component may be too small for visual check by the operator, it is recommendable to conduct reconfirmation so as to find any remaining debris by the condition sensor 17. Therefore, in case the component to be mounted is large enough for visual checking, it may be possible to eliminate such reconfirmation process, and the work flow may goes back directly to step #103 for resuming series of mounting operations.

In the present embodiment, the structure element 10 as shown in Fig. 7 is used for component mounting operations. Accordingly, confirming process whether any debris remains at the component holder (in this case, a nozzle 14) after release of the component 3 may be performed by the condition sensor 17 at detecting station 16. It is extremely preferable to use already existing devices for this purpose provided in the component mounting apparatus, such as the condition sensor 17, since using existing devices would avoid any problems related to additional space and cost. It may also be possible, however, to provide an additional detecting device for this checking or confirmation purpose.

Next, the 2nd embodiment of a method and an apparatus for component mounting according to the present invention is now described. In the present embodiment, all the nozzles are subjected to checking whether any debris exists immediately after production operations are started, and component pick up operation is started only after the above checking procedure is conducted. The term "operation start" here may includes any production operation start timing, such as starting different production lot after production of specific model has completed, starting production operations after mechanical problems, starting production operations after operators' break time, or starting production operations after operators' shift change. In addition, if it is necessary, the detection procedures mentioned above may be performed periodically at a certain time interval during the production operations. The term "immediately after production operations are started" means a timing immediately after starting the operation by, for example, turning on the electric power, once the component mounting apparatus was stopped for any reasons such as mentioned above.

Referring to Fig. 2, after staring production operations at step #201, a circuit substrate is fed in and firmly held by the circuit substrate holder at step #202. Before starting component pick up operation at step #206, a nozzle 14 is checked whether any debris remains and exists on the surface of the tip by using condition sensor 17 at the detecting station 16 at step #203. If no debris is found at the tip of the nozzle 14 at step #204, the flow goes to step #205 to confirm whether all the nozzles 14 are checked. If all the nozzles are checked and confirmed that no debris remains at any nozzles, the work flow goes to step #206 for starting component pick up operation. If not all the nozzles are checked yet at step #205, the work flow goes back to step #203 to repeat the above checking procedure for finding any debris on other nozzles until all the nozzles 14 are checked.

If debris is found at one of the nozzles 14 at step #204, the flow goes to step #215 where component mounting apparatus is stopped, and/or warning is generated such as displaying error message, or making an alarm. At step #216, the operator checks the tip surface of the nozzle 14 where the debris was found, and takes necessary maintenance work for removing the debris. And then the operator turns on the power of the apparatus at step #217 for restarting production operations upon removal of the debris. After the production operations are restarted, component pick up operation at pick up station 15 is skipped at the first round of the index 11 rotation, but rather, tips of all the nozzles 14 are checked one more time whether any debris remains by using condition sensor 17 at detecting station 16. These processes are repeated until it is confirmed, at step #205, that all the nozzles 14 are free from debris.

After it is confirmed that no debris remains at any tips of the nozzles 14 at step #205, a component 3 is picked up at step #206, and the holding condition of the component 3 is checked by condition sensor 17 at detecting station 16 at step #207. If it is determined that the component is held in proper condition for mounting, sucking point and tilt angle of the component are recognized at imaging station at step #208. If the sucking point and the tilt angle are recognized properly, displacement value $\Delta a$ and the tilt angle $\alpha$ are measured at step #209. Necessary position and/or angle corrections are made to the component based on the measurements of the displacement $\Delta a$ and the tilt angle $\alpha$. After the circuit substrate 21 is positioned at the mounting station 20 at step #210, the component 3 is mounted on the circuit substrate 21 at step #211. Next, at step #212, it is checked whether the component just mounted is the last one to be mounted or not, and if it is confirmed that the component is the last one, the work flow goes to step #213 where it is checked whether the circuit substrate is the final one or not. If it is confirmed that the circuit substrate is the final one, the circuit substrate 21 is pulled out from the apparatus and the production operations are completed.

If it is found, at step #207, that no component is sucked at the component holding condition detecting process, the next round of mounting operation is skipped, and the flow goes back to step #206 for sucking a new component. If it is determined that the component is in improperly held condition, or the sucked component is a false one, such component 3 are released at releasing station 22 as shown at step #218, and the work flow returns to step #206 for picking up a new component 3.

As described in the 1st embodiment, order of nozzle operations for rotary type component mounting apparatus is fixed in association with the index 11 rotation. As for XY robot type component mounting apparatus, for example, the nozzles may be arrange to move to detecting station 16 first for finding any debris on the nozzle tips, and then move to the pick up station 15 for component pick up by modifying logics of nozzle movement.

As described in the 1st embodiment, the reason for checking one more time whether or not any debris remain after the operator checked nozzle condition is to avoid any possible failure of the operator's visual check. In case the component is large enough for visual checking, it may be possible to directly goes to step #206 to start component pick up operation, without having such reconfirmation procedure. Further, although the example of the component mounting apparatus shown above has a plurality of nozzles 14, the present invention may be applied to the type having a single nozzle. In such a single nozzle type, if it is confirmed that no debris remains at that nozzle, the work flow may directly goes to step #206 for starting component sucking.

1st and 2nd embodiments may be combined. Namely, after starting production operations, all the nozzles are checked whether any debris remains before component pick up operation is started, and pick up of a component 3 may be allowed only after confirmation is made that no debris is found. Further, if it is determined that the component is in improperly held condition, the sucked component is a false one, or component holding point is not properly recognized, the nozzle 14 releases such a component and would not pick up a new component until it is confirmed that no debris remains at the tip of the nozzle by using the condition sensor 17. As described in the 1st embodiment, although it is preferable to perform the above confirmation procedure for finding any debris at the nozzle 14 by using the existing detecting devices, such as the condition sensor 17, it is also possible to conduct such procedure by using additionally provided detecting device.

Next, a method and an apparatus of component mounting according to 3rd embodiment of the present invention are now described by referring to Fig. 3. According to the method of component mounting of the present embodiment, allowable range of the displacement $\Delta a$ between the sucking point of the component 3 and the nozzle 14 is predetermined. If the displacement measured is out of such an allowable range, the component 3 is to be released into the collecting box 23 at the releasing station 22. Further, according to the method of component mounting of the present embodiment, a controller is provided for decelerating moving speed of the nozzle 14 until the nozzle 14 releases the component 3, in case it is determined that the displacement $\Delta a$ is out of the predetermined allowable range. Decelerating the moving speed of the nozzle is made for the purpose of avoiding any possible falling of the component 3 held in improper condition, thereby avoiding possible damages to other components already mounted on the circuit substrate, or avoiding negative impact on component mounting operations conducted by other nozzles 14.

Referring to Fig. 3, when production operation are started at step #301, a circuit substrate 21 is fed in and firmly held by the circuit substrate holder at step #302, and the component 3 is picked up at step #303. Then the work flow goes to step #304 for detecting the holding condition of the component 3 using the condition sensor 17 at detecting station 16. If it is confirmed that the holding condition is within the range for proper mounting, the flow goes to step #305 for recognizing component sucking point 31 and tilt angle by the imaging device 19. If the sucking point 31 and the tilt angle are recognized properly, the displacement value $\Delta a$ between the sucking point 31 of the component 3 and the nozzle 14 is measured at step #307. At step #308, it is checked whether the measured displacement $\Delta a$ between the

sucking point 31 and the nozzle 14 is within the allowable range or not. If the displacement Δa falls within the range, necessary correction of position and/or angle are made to the component 3 based on measurement results of the displacement Δa and the tilt angle α. Then the work flow goes to step 309 where the circuit substrate 21 is positioned at the mounting station 20, and the component 3 is mounted on the circuit substrate at step #310. Next, at step #311, it is checked whether the component 3 just mounted is the last one to be mounted, and if it is confirmed that the component is the last one, the work flow goes to step #312 for checking whether the circuit substrate 21 is the final one for the production lot or not. If it is confirmed that the circuit substrate 21 is the final one, the circuit substrate 21 is pulled out from the apparatus, and the production operations are completed at step #313.

In the prior art, the allowable range of the displacement Δa between the sucking point 31 of the component 3 and the targeted point 32 of the nozzle 14 (see Fig. 9) is given based on the field of the imaging device used for measuring the displacement Δa. According to such a prior art method, the space between the component 3 to be mounted and the components already mounted on the circuit substrate may not be arranged narrower than 0.5 mm. If the allowable range of the displacement is given base on the field of the imaging device, magnitude of the position correction of the component becomes as large as the field of the imaging device Therefore, such magnitude of the position correction between the nozzle 14 and the circuit substrate 21 may become too large, so that the tip of the nozzle 14 may interfere with the adjacent component already mounted on the circuit substrate, and may cause a damage against it. On the contrary, according to the method of the present embodiment, as mentioned above, the allowable range of displacement value Δa can be selectively predetermined, which may be determined small enough to avoid any interfere and/or damages against the adjacent component caused by the approaching nozzle, and to mount a new component properly. The displacement value Δa may be selected at any preferred range on component by component basis, depending upon layout of the circuit substrate and/or size of the component to be mounted. According to the present method, the space between two adjacent components may be arranged as small as 0.2 mm.

If it is determined by the condition sensor 17, at step #304, that no component is sucked, next component mounting operation is skipped, and the work flow returns to step #303 where a new component is picked up. If it is determined at step #304, that the component is held in improper condition or the component is a false one, or the sucking point 31 is not recognized at step #306, or if it is determined at step #308 that the displacement value Δa is out of the allowable range, speed of the index 11 rotation shown by an arrow 13 (see Fig. 7) for moving nozzles 14 is decelerated, and then the component 3 is released into the collecting box 23 at releasing station 22 at step #315. After the component 3 is released at step #316, speed of the index 11 rotation shown by the arrow 13 is accelerated up to the normal level so as to resume normal production operations.

In case of the rotary type component mounting apparatus as shown above, speed of the nozzle 14 is controlled by the index 11 rotation. In case of the XY robot type component mounting apparatus, similar effect may be achieved by controlling the speed of driving devices which move the nozzle(s) in X and Y directions.

According to a method of the present embodiment shown in Fig. 3, two different procedures, i) procedure of selectively determining the allowable range of the displacement value Δa between the sucking point 31 and the nozzle 14, and ii) procedure of decelerating speed of the nozzle 14 until the nozzle 14 releases the component, are incorporated together. These two procedures, however, are completely independent from each other, and, therefore, these two procedures may be applied either jointly or separately.

Further, this 3rd embodiment of the present invention may be applied in conjunction with either 1st or 2nd embodiment or both of them. Namely, after production operations are started, all nozzles 14 are checked, before starting component pick up operation, whether or not any debris exists on the tips of nozzles. If no debris is found, the sucking operation by the nozzles 14 is started. If debris is found, nozzle speed is reduced until it reaches to the releasing station 22. Further, if it is determined that the component is held in improper condition for mounting, the sucked component is a false one, or the sucking point 31 cannot be recognized, or if it is determined that the displacement value Δa is out of the allowable range, speed of the nozzles 14 is decelerated, and the component 3 is released into the collecting box 23 at releasing station 22. After the component is released, speed of the nozzle is accelerated up to normal level. After the component 3 is released, that particular nozzle once skips sucking operation, but rather the nozzle is checked for confirming whether any debris remains at the tip by using the condition sensor 17 at detecting station 16. If no debris is found, the nozzle 14 starts component sucking operation.

4th embodiment of the present invention is related to a device for removing debris from the component holder. In each of the embodiment described above, if any debris is found at the component holder, the operator once stops the operation of component mounting apparatus, as shown in steps #116, #117 in Fig. 1, removes the debris from the component holder manually by, for example, cleaning, and then restarts the operation of the apparatus. According to the present embodiment, instead of the operator's manual work for removing debris, a device for removing such debris automatically are provided, thereby productivity of the component mounting apparatus may be improved.

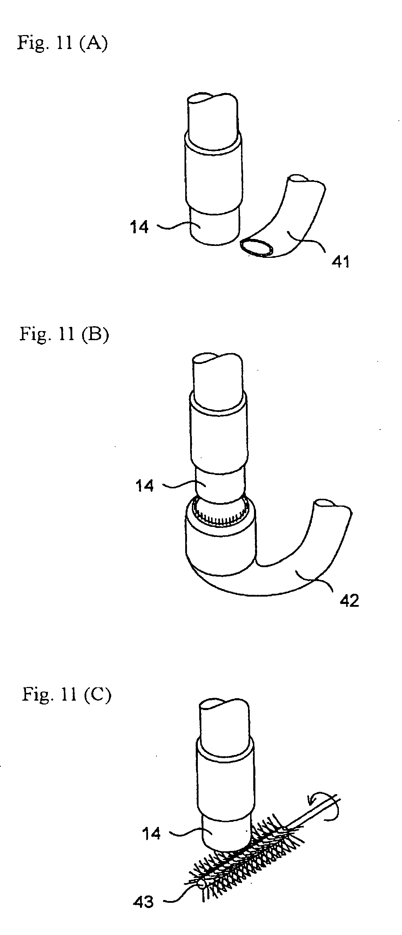

One aspect of such debris removing device, as shown in Fig 11(a), includes an air nozzle 41 to blow off compressed air therefrom. If any debris are found on a component holder, the air nozzle 41 blows compressed air toward the component holder when it approaches nearby. In this instance, the compressed air is blown from the bottom of the component holder 14 obliquely so that the debris removed from the component holder may be blown off toward the direction away from the circuit substrate and/or other component holders 14.

Another aspect of the debris removing device includes a suction nozzle 42 as shown in Fig. 11(b). By locating such a suction nozzle 42 near the component holder 14 and by introducing vacuum, debris remaining at the component holder 14 may be sucked into the suction nozzle 42. An opening portion of such a suction nozzle 42 may be made by elastic material such as rubber, so that the component holder 14 and the suction nozzle 42 may not suffer any damages even when both of them collide with each other. Also, by adding brush like elastic material surrounding the opening of the suction nozzle 42, and contacting this material with the component holder, debris may be more easily sucked into the nozzle opening. The benefit of using such a suction nozzle 42 is that debris are more securely removed, and that any damages caused by the removed debris against the circuit substrate and/or other component holders may reliably be avoided.

Another alternative of the debris removing device is a brush like material 43, such as wire brush, as shown in Fig. 11(c). By rubbing such a brush like material 43 on the surface of the component holder 14, the- component holder 14 may be cleaned and the debris may be removed therefrom. In such an instance, it is desirable to move or rotate the brush like material 43 in such a manner that the removed debris may be thrown to a direction away from the circuit substrate and/or other component holders. Further, if it is necessary, a net type material may be provided beneath the brush like material 43 for collecting the removed debris.

If the debris removing device, as described above, is provided at any location between releasing station 22 and pick up station 15 of the index 11 shown in Fig. 7, it becomes possible to collect debris without causing any negative impacts on a series of component mounting operations starting from component pick up to either component mounting or component releasing. The aforementioned debris removing device may be arranged in a retracted position during normal operation, and the device may be stretched out only when the component holder, on which debris is found, comes close to the debris removing device. These debris removing devices shown above may be used in any combination thereof.

By providing such debris removing devices, when debris are found, such debris may be removed without stopping the component mounting apparatus, and hence productivity of the component mounting apparatus may be improved. When these kinds of debris removing device are used for cleaning the component holder, this particular component holder does not pick up a new component at a next round of the index rotation, but rather, before restarting component pick up operation, the nozzle is subjected to confirming whether the debris is actually removed from it at the detecting station 16. By adding such confirmation procedure, any risks caused by possibly remaining debris may be avoided. It is more effective to stop the component mounting apparatus and take necessary maintenance action by an operator only when debris is found at such confirmation procedure. These debris removing devices may be used not only for the case when debris is found at the component holder, but for other cases, such as a case when the component holder releases a component in improperly held condition. Or these debris removing devices may be used on a regular basis in case, for example, debris is found so often during production operations.

If the component holder is a nozzle type for sucking a component, the nozzle itself may be used for removing debris, instead of providing the above mentioned debris removing devices. That is, the nozzle is normally provided with both vacuum for sucking a component and compressed air for releasing a component. Accordingly, if debris is found on the nozzle, compressed air, which may be at a higher pressure level than the compressed air used for normal releasing operation, is introduced to the nozzle for blowing off the compressed air from the nozzle opening, which may be used for removing debris. Since debris normally remains at the outer surface of the nozzle, such blow off of the compressed air from the nozzle opening may be used for removing the debris without additionally providing debris removing devices. Or such a nozzle may be used in combination with the debris removing device mentioned above.

In case the nozzle itself is used for removing the debris as described above, it is desirable to provide a debris collecting device, such as a folding net, so that the removed debris may not collide with the circuit substrate. Also it is desirable to reconfirm whether any debris exists on that particular nozzle before the nozzle restarts component sucking operation.

5th embodiment of the present invention is related to a computer readable storage medium which stores a program for performing a method of component mounting as described in each of the aforementioned embodiments. Fig 4 is a circuit diagram showing various parts incorporated in respective component mounting apparatus described above. The component mounting system has a hardware section and a software section. The hardware section includes component supply 2, index 11, placement head 12, condition sensor 17, imaging device 18, and circuit substrate holder. The software section includes various processing units for controlling necessary operations for supplying component, sucking component, measuring tilt angle correction amount, determining component holding condition, imaging component, recognizing sucking position, and correcting position. The hardware and software are integrated with the controller that controls overall operations of the elements. Each of the hardware elements whose operations are already described above has various drivers connected through respective lines extending out from the elements. The controller processes and controls all of the operations based on the processing and determinations made by each of the software elements shown in left side of Fig. 4

Among other things, the component supply processing unit controls the movement of the component supply 2 so that the component 3 is properly placed at the pick up position. The component sucking processing unit controls timing and vacuum for component sucking by nozzles 14 attached to the placement heads 12. The unit for measuring tilt angle corrections measures the amount of angular correction (θ angle) about the center axis of the nozzle 14 for mounting a component 3 on a predetermined position by means of the placement head 12. The unit for determining the component holding condition determines whether the sucked component 3 is in proper condition for mounting. The component recognition unit controls the recognition by the imaging device and the field of the imaging device. The unit for detecting target point of the circuit substrate recognizes the target point. The position correction unit controls the moving distance of the circuit substrate holder for mounting the component at the proper mounting position.

The computer readable storage medium according to the present embodiment stores a program for performing a method of component mounting by using the component mounting apparatus as structured above. Namely, the storage medium stores a program performing a series of operations in a proper order including steps of:

sucking predetermined components 3 from the component supply 2 using a single or a plurality of nozzles 14;
detecting whether or not the components 3 held by the nozzle 14 is in proper condition for mounting;
if it is determined that the component is held in proper condition for mounting, performing a series of operations including recognizing the sucking point 31 of the component 3, measuring a displacement value between the nozzle 14 and the sucking point 31 of the component 3 as well as a tilt angle of the component 3, making necessary corrections to location and/or angle, and mounting the component 3 onto the predetermined position of the circuit substrate;
if it is determined that the component is held in improper condition for mounting, or the component is not properly imaged at the imaging process, performing a series of operations including releasing the component into the collecting box 23 at the predetermined releasing station 22 instead of mounting it;
after the nozzle 14 has released the component, confirming whether any debris exists at the nozzle 14 before the nozzle 14 sucks a new component;
if no debris is found at the above confirming step, sucking a new component to be mounted with the nozzle 14;
if debris is found at the above confirming step, stopping the component mounting apparatus, and generating a warning for the operator, and
after the production operations are restarted upon removal of the debris from the nozzle 14, sucking a new component 3 for subsequent mounting with the nozzle 14. Since details of each of the steps included above are already described in the aforementioned embodiment, duplicated explanation may not be needed.

The computer readable storage medium as described above may store a program for performing further steps of:

immediately after starting of production operations, checking whether any debris exists at the nozzle 14 before the nozzle 14 starts component pick up operation from the component supply 2;
if no debris is found at the above checking step, picking up a first component 3 to be mounted;
if debris is found at the above detecting step, stopping the production operations, and
after the production operations are restarted upon removal of the debris, picking up a first component 3 to be mounted with the nozzle 14.

The computer readable storage medium as described above may also store a program for performing further steps of:

after production operations are restarted and before the nozzle 14 picks up a new component, reconfirming whether any debris exists at the nozzle 14;
if no debris is found at the nozzle 14 by the above reconfirming step, picking up a new component 3 by the nozzle 14, and
if debris is found by the above reconfirming step, stopping the production operations again.

The programs described above may be stored in a storage medium, such as a floppy disc or a CD-ROM. A device capable of reading such a storage medium is provided to the component mounting apparatus, and such a device reads the programs so that the programs may be stored in the memory of the controller of the component mounting apparatus. Consequently, the component mounting apparatus may perform operations defined by such a program, and hence a method of component mounting according to the present invention as described in each of the precedent embodiments may be carried out.

In the description of the present embodiment, a nozzle 14 is used as an example of the component holder 14, but other types of component holders such as a mechanical chuck type may be used.

As described above, according to the method and apparatus for component mounting of the present invention, whether any debris exists at the component holder or not, or whether unnecessary component is certainly released or not may be checked and confirmed by using a detecting device. Such a detecting device needs not to be additionally provided to the component mounting apparatus, but rather detecting devices, such as a condition sensor or an imaging device already provided to the component mounting apparatus, may be utilized. If the debris is found by such a detecting device, the debris may be removed either manually by an operator who stops the component mounting apparatus and cleans it, or automatically by a debris removing device using compressed air or brush like material for removing the debris. If it is necessary, reconfirming procedure to find whether or not the debris still exists may be performed by using the same detecting device. By performing the production operations as described above, defective products may rarely be produced, and hence the yield, or the ratio of un-defective products may be improved. Further, the method according to the present invention may avoid damages on the component holder, and hence avoiding deterioration of the productivity due to unnecessary mechanical problems of the apparatus.

According to the present invention, by decelerating moving speed of the component holder until it reaches the releasing station for releasing a component held in improper condition, it is possible to reduce risks of falling off of the component held by the component holder in unstable condition. Therefore, according to the method or the apparatus for component mounting of the present invention, producing circuit boards with higher quality may be realized more stably.

Further, by reading the storage medium by a computer, and controlling a component mounting operations by using such a computer, defective products may rarely be produced during the component mounting operations. Therefore, the component mounting operations according to the present invention may improve the yield, or a ratio of nondefective products, and may avoid deterioration of productivity due to unnecessary mechanical troubles of the apparatus.

<u>It follows a list of further embodiments of the invention:</u>

Embodiment 1. A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and
releasing the component (3) at a releasing station (22) instead of mounting it if it is determined at said detecting step that the component (3) is held in improper condition for mounting, and then picking up a new component (3) by the component holder (14),
wherein the method further includes a step of confirming, prior to said step of picking up a new component (3), whether any debris exists at the component holder (14) after said component holder (14) has released the component held in improper condition.

Embodiment 2. A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and
releasing the component (3) at a releasing station (22) instead of mounting it if it is determined at said detecting step that the component (3) is held in improper condition for mounting, and then picking up a new component (3) by the component holder (14),
wherein the method further includes a step of checking whether any debris exists at the component holder (14) immediately after production operations are started, and before the component holder (14) picks up a first component (3)

Embodiment 3. A method with the features of embodiment 1 or 2, wherein, when debris is found at said step of checking and/or confirming whether any debris exists at the component holder (14), the method further includes a step of reconfirming whether any debris exists at the component holder (14) immediately after production operations are restarted upon removal of the debris from said component holder (14), and prior to the step of picking up a new component (3) by said component holder (14).

Embodiment 4. A method with the features of embodiment 1 to 3,
wherein the step of checking, confirming or reconfirming whether any debris exists at the component holder (14) is performed by either one of the detecting devices (17, 19) used for detecting component holding condition.

Embodiment 5. A method with the features of embodiment 1 to 4,
wherein the method further includes either one of or both of a step of stopping production operations, and a step of generating warning, if debris is found at the step of checking, confirming or reconfirming whether any debris exists at the component holder (14).

Embodiment 6. A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and releasing the component (3) at a releasing station (22) instead of mounting it if it is determined at said detecting step that the component (3) is held in improper condition for mounting, and then picking up a new component (3) by the component holder (14),
wherein, if a displacement value between the component (3) and the component holder (14) is out of a predetermined allowable range, it is determined that the component (3) is held in improper condition for mounting.

Embodiment 7. A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and releasing the component (3) at a releasing station (22) instead of mounting it if it is determined at said detecting step that the component (3) is held in improper condition for mounting, and then picking up a new component (3) by the component holder (14),
wherein moving speed of the component holder (14) until it reaches releasing station (22) for releasing the component (3) is decelerated, if it is determined at said step of detecting component holding condition that the component (3) is held in improper condition for mounting.

Embodiment 8. A method with the features of embodiment 1 to 7,
wherein a plurality of the component holders (14) are deployed circumferentially, and each of the plurality of component holders mounts a component (3) sequentially while the component holders deployed circumferentially rotate intermittently.

Embodiment 9. A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and releasing the component (3) at a releasing station (22) instead of mounting it if it is determined at said detecting step that the component (3) is held in improper condition for mounting, and then picking up a new component (3) by the component holder (14),

wherein the method further includes steps of:

confirming, prior to picking up a new component by the component holder (14), whether any debris exists at the component holder (14) after said component holder (14) has released a component held in improper condition for mounting;
picking up a new component by the component holder (14) if it is determined that no debris is found at said step of confirming whether any debris exists;
stopping production operations, if debris is found at said step of confirming whether any debris exists, and picking up a new component (3) by the component holder (14) after the production operations are restarted upon removal of the debris from the component holder (14) where debris was found.

Embodiment 10. A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and
releasing the component (3) at a releasing station (22) instead of mounting it if it is determined at said detecting step that the component (3) is held in improper condition for mounting, and then picking up a new component (3) by the component holder (14),

wherein the method further includes steps of:

checking whether any debris exists at the component holder (14) immediately after production operations are started and before a first component is picked up;
picking up the first component (3) if no debris is found at said step of checking whether any debris exists immediately after production operation are started;
stopping production operations if debris is found at said step of checking whether any debris exists immediately after production operation are started;
picking up a new component (3) by the component holder (14) after the production operations are restarted upon removal of the debris from the component holder (14) where the debris was found.

Embodiment 11. A method with the features of embodiment 9 or 10, wherein the method further includes a step of reconfirming whether any debris exists at the component holder (14), after the production operations are restarted upon removal of debris from the component holder where the debris was found.

Embodiment 12. A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and
releasing the component (3) at a releasing station (22) instead of mounting it if it is determined at said detecting step that the component (3) is held in improper condition for mounting, and then picking up a new component (3) by the component holder (14),

wherein the method further includes steps of:

comparing a displacement value between the component (3) and the component holder (14) with a predetermined allowable range of displacement, prior to detecting holding condition of the component (3);
correcting position of the component (3) based on the displacement, and mounting the component (3) on the mounting position of the circuit substrate (21) if the displacement between the component (3) and the component holder (14) falls within said allowable range of the displacement, and
releasing the component (3) at releasing station (22), instead of mounting the component on the circuit substrate (21), if the displacement between the component (3) and the component holder (14) is out of the allowable range of the displacement.

Embodiment 13. A component mounting apparatus comprising:

a supplying device (7) for supplying components (3) to a component supply (2);
a placement head (12) for picking up the component (3) from the component supply (2), and mounting the component (3) on a circuit substrate (21) which is positioned and firmly held;
a detecting device (17, 19) for detecting holding condition of the component (3) held by a component holder (14) attached to the component placement head (12);
a collecting box (23) for collecting components (3) if it is determined by the detecting device (17,19) that the components (3) are held in improper condition for mounting, and
a transferring device (11) for transferring the placement head (12) to at least stations of picking up components (15), detecting component holding condition (16), mounting the component (3) on the circuit substrate (20), and collecting components (22),
wherein the component mounting apparatus has a controller which controls the production operations so as to perform confirming operation to confirm any debris exists at the component holder (14) of the placement head (12) by means of the detecting device (17, 19), after the placement head (12) has released the component (3) held in improper condition for mounting and before the placement head (12) picks up a new component (3).

Embodiment 14. A component mounting apparatus comprising:

a supplying device (7) for supplying components (3) to a component supply (2);
a placement head (12) for picking up the component (3) from the component supply (2), and mounting the component (3) on a circuit substrate (21) which is positioned and firmly held;
a detecting device (17, 19) for detecting holding condition of the component (3) held by a component holder (14) attached to the component placement head (12);
a collecting box (23) for collecting components (3) if it is determined by the detecting device (17,19) that the components (3) are held in improper condition for mounting, and
a transferring device (11) for transferring the placement head (12) to at least stations of picking up components (15), detecting component holding condition (16), mounting the component (3) on the circuit substrate (20), and collecting components (22),
wherein the component mounting apparatus has a controller which controls the production operations so as to perform a checking operation whether any debris exists at the component holder (14) of the placement head (12) by means of the detecting device (17, 19) immediately after production operations are started and before the placement head (12) picks up a first component (3).

Embodiment 15. A component mounting apparatus with the features of embodiment 13 or 14, wherein the detecting device (17, 19) detects a displacement value between the component (3) and the component holder (14), and determines that the component (3) is held in improper condition for mounting if said displacement is out of a predetermined allowable range of displacement.

Embodiment 16. A component mounting apparatus with the features of embodiment 13 or 14, wherein production operations are stopped and/or a warning is generated if debris is found at the checking and/or confirming operation whether any debris exists at the component holder (14).

Embodiment 17. A component mounting apparatus with the features of embodiment 13 or 14, wherein the apparatus further comprises a debris removing device for removing debris from the component holder (14), which debris removing device cleans the component holder (14) and removes debris from it (14) in case debris is found at the checking and/or confirming operation whether any debris exists at the component holder (14), or in case the component holder (14) has released the component (3) held in improper condition for mounting into the collecting box (23).

Embodiment 18. A component mounting apparatus with the features of embodiment 17, wherein the debris removing device comprises any one of an air nozzle to blow off compressed air toward the component holder (14), a vacuum suction nozzle to cause suction effect in the vicinity of the component holder (14), a brush like material to clean the component holder, or any combination thereof.

Embodiment 19. A component mounting apparatus comprising:

a supplying device (7) for supplying components (3) to a component supply (2);
a placement head (12) for picking up the component (3) from the component supply (2), and mounting the component (3)' on a circuit substrate (21) which is positioned and firmly held;
a detecting device (17, 19) for detecting holding condition of the component (3) held by a component holder (14) attached to the component placement head (12);
a collecting box (23) for collecting components (3) if it is determined by the detecting device (17,19) that the components (3) are held in improper condition for mounting, and
a transferring device (11) for transferring the placement head (12) to at least stations of picking up components (15), detecting component holding condition (16), mounting the component (3) on the circuit substrate (20), and collecting components (22),
wherein the component mounting apparatus has a controller which decelerates moving speed of the placement head (12) equipped with the component holder (12) until the component holder releases the component (3) held in improper condition for mounting into the collecting box (23) .

Embodiment 20. A component mounting apparatus with the features of embodiment 13 to 19, wherein the transferring device (11), comprises an index (11) having a plurality of placement heads (12) circumferentially around the index (11), and rotating them intermittently.

Embodiment 21. A component mounting apparatus with the features of embodiment 13 to 20, wherein the component holder (14) comprises a nozzle for holding the component (3) by sucking it with vacuum.

Embodiment 22. A component mounting apparatus with the features of embodiment 21, wherein the component mounting apparatus has a controller which controls the nozzle (14), or the component holder, to blow off compressed air from the nozzle opening after the nozzle (14)has released the component (3) held in improper condition for mounting and before the nozzle (14) picks up a new component (3), or when debris is found at the nozzle.

Embodiment 23. A component mounting apparatus with the features of embodiment 22, wherein the component mounting apparatus has a controller for controlling the production operations so as to perform confirming operation whether any debris exists at the nozzle (14) after the nozzle (14) blows off compressed air, and before the nozzle (14) picks up a new component (3).

Embodiment 24. A computer readable storage medium storing a program for performing operations including steps of:

picking up a component (3) from a component supply (2) by a component holder (14);
detecting the component (3) whether it is held by the component holder (14) in proper condition for mounting;
measuring a displacement between the component holder (14) and a sucking point of the component (3), making necessary correction of position based on the measurement, and then mounting the component (3) on a circuit substrate (21) if it is determined that the component (3) is held in proper condition for mounting at said detecting step;
releasing the component (3) into a collecting box (22), instead of mounting it on the circuit substrate (21), if it is determined that the component (3) is held in improper condition for mounting;
confirming whether any debris exists at the component holder (14) which has released the component (3) held in improper condition into the collecting box (23);
picking up a new component (3) by the component holder (14) if no debris is found at said confirming step;
stopping production operations if debris is found at said confirming step;
picking up a new component (3) to be mounted next by the component holder (14) after the production operations are restarted upon removal of the debris from the component holder (14) where such debris was found.

Embodiment 25. A computer readable storage medium with the features of embodiment 24, wherein the medium stores a program performing further operations including steps of:

checking whether any debris exists at the component holder immediately after production operations are started and before the component holder picks up a first component (3) from component supply (2);
picking up the first component (3) by the component holder (14) if no debris is found at said checking step;
stopping production operations if debris is found at said checking step, and
picking up the first component (3) by the component holder (14), after the production operations are restarted upon removal of the debris from the component holder (14) where such debris was found.

Embodiment 26. A computer readable storage medium with the features of embodiment 24 or 25, wherein the medium stores a program performing further operations including steps of:

reconfirming whether any debris exists at the component holder immediately after production operations are restarted and before the component holder (14) picks up a new component (3);
picking up a new component (3) with the component holder (14) if no debris is found at said reconfirming step, and stopping production operations if debris is found at said reconfirming step.

## Claims

**1.** A method of component mounting performing series of production operations including steps of:

picking up a component (3) supplied to a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and
releasing the component (3) at a releasing station (22) instead of mounting it if it is determined at said detecting step that the component (3) is held in improper condition for mounting, and then picking up a new component (3) by the component holder (14),
wherein, if a displacement value between the component (3) and the component holder (14) is out of a predetermined allowable range prepared for avoiding any interference with other components already mounted on the circuit substrate, it is determined that the component (3) is held in improper condition for mounting, and
wherein moving speed of the component holder (14) until it reaches releasing station (22) for releasing the component (3) is decelerated, if it is determined at said step of detecting component holding condition that the component (3) is held in improper condition for mounting.

**2.** A method of component mounting performing series of production operations including steps of:

picking up a component (3) supplied to .a component supply (2) by a component holder (14);
detecting holding condition of the component (3) held by the component holder (14);
mounting the component (3) on a mounting position of a circuit substrate (21) by the component holder (14) if it is determined at said detecting step that the component (3) is held in proper condition for mounting, and
releasing the component (3) at a releasing station (22) instead of mounting it if it is determined at said detecting step that the component (3) is held in improper condition for mounting, and then picking up a new component (3) by the component holder (14),
wherein the method further includes steps of:

comparing a displacement value between the component (3) and the component holder (14) with a predetermined allowable range of displacement prepared for avoiding any interference with other components already mounted on the circuit substrate, prior to detecting holding condition of the component (3);
correcting position of the component (3) based on the displacement, and mounting the component (3) on the mounting position of the circuit substrate (21) if the displacement between the component (3) and the component holder (14) falls within said allowable range of the displacement, and
releasing the component (3) at releasing station (22), instead of mounting the component on the circuit substrate (21), if the displacement between the component (3) and the component holder (14) is out of the allowable range of the displacement,
wherein moving speed of the component holder (14) until it reaches releasing station (22) for releasing the component (3) is decelerated, if it is determined at said step of detecting component holding condition that the component (3) is held in improper condition for mounting.

**3.** A component mounting apparatus comprising:

a supplying device (7) for supplying components (3) to a component supply (2);
a placement head (12) for picking up the component (3) from the component supply (2), and mounting the component (3) on a circuit substrate (21) which is positioned and firmly held;
a detecting device (17, 19) for detecting holding condition of the component (3) held by a component holder (14) attached to the component placement head (12);
a collecting box (23) for collecting components (3) if it is determined by the detecting device (17,19) that the components (3) are held in improper condition for mounting, and
a transferring device (11) for transferring the placement head (12) to at least stations of picking up components (15), detecting component holding condition (16), mounting the component (3) on the circuit substrate (20), and collecting components (22),
wherein the component mounting apparatus has a controller which decelerates moving speed of the placement head (12) equipped with the component holder (12) until the component holder releases the component (3) held in improper condition for mounting into the collecting box (23).

**4.** A component mounting apparatus according to claim 3, wherein the transferring device (11) comprises an index (11) having a plurality of placement heads (12) circumferentially around the index (11), and rotating them intermittently.

5. A component mounting apparatus according to claims 3 or 4, wherein the component holder (14) comprises a nozzle for holding the component (3) by sucking it with vacuum.

6. A component mounting apparatus according to claim 5, wherein the component mounting apparatus has a controller which controls the nozzle (14), or the component holder, to blow off compressed air from the nozzle opening after the nozzle (14) has released the component (3) held in improper condition for mounting and before the nozzle (14) picks up a new component (3), or when debris is found at the nozzle.

7. A component mounting apparatus according to claim 6, wherein the component mounting apparatus has a controller for controlling the production operations so as to perform confirming operation whether any debris exists at the nozzle (14) after the nozzle (14) blows off compressed air, and before the nozzle (14) picks up a new component (3).

## Patentansprüche

1. Verfahren zum Montieren von Komponenten, das eine Serie von Fertigungsschritten durchführt, einschließlich der folgenden Schritte:

   Aufnehmen einer Komponente (3), die einer Komponentenzuführung (2) durch einen Komponentenhalter (14) zugeführt wird,
   Erkennen eines Haltezustands der durch den Komponentenhalter (14) gehaltenen Komponente (3),
   Montieren der Komponente (3) in einer Montageposition auf einem Schaltungssubstrat (21) durch den Komponentenhalter (14), falls in dem Erkennungsschritt festgestellt wird, dass die Komponente (3) im richtigen Zustand zum Montieren gehalten wird, und
   Freigeben der Komponente (3) in einer Freigabestation (22) anstelle des Montierens, falls in dem Erkennungsschritt festgestellt wurde, dass die Komponente (3) für das Montieren im falschen Zustand gehalten wird, und dann Aufnehmen einer neuen Komponente (3) durch den Komponentenhalter (14),
   wobei bestimmt wird, dass die Komponente (3) in einem zum Montieren falschen Zustand gehalten wird, falls ein Versatzwert zwischen der Komponente (3) und dem Komponentenhalter (14) außerhalb eines vorbestimmten zulässigen Bereichs liegt, der vorgesehen ist, um irgendwelche Beeinträchtigung mit anderen bereits auf dem Schaltungssubstrat montierten Komponenten zu vermeiden, und wobei
   die Bewegungsgeschwindigkeit des Komponentenhalters (14) herabgesetzt wird, bis er die Freigabestation (22) zum Freigeben der Komponente (3) erreicht, falls in dem Erkennungsschritt des Haltezustands der Komponente bestimmt wird, dass die Komponente (3) in einem zum Montieren falschen Zustand gehalten wird.

2. Verfahren zum Montieren von Komponenten, das eine Serie von Fertigungsschritten durchführt, einschließlich der folgenden Schritte:

   Aufnehmen einer Komponente (3), die einer Komponentenzuführung (2) durch einen Komponentenhalter (14) zugeführt wird,
   Erkennen eines Haltezustands der durch den Komponentenhalter (14) gehaltenen Komponente (3),
   Montieren der Komponente (3) in einer Montageposition auf einem Schaltungssubstrat (21) durch den Komponentenhalter (14), falls in dem Erkennungsschritt festgestellt wird, dass die Komponente (3) im richtigen Zustand zum Montieren gehalten wird, und
   Freigabe der Komponente (3) in einer Freigabestation (22) anstelle des Montierens, falls in dem Erkennungsschritt festgestellt wurde, dass die Komponente (3) für das Montieren im falschen Zustand gehalten wird, und dann Aufnehmen einer neuen Komponente (3) durch den Komponentenhalter (14),
   wobei das Verfahren darüber hinaus die Schritte aufweist:

      Vergleichen eines Versatzwertes zwischen der Komponente (3) und dem Komponentenhalter (14), vor dem Erkennungsschritt des Haltezustands der Komponente (3), mit einem vorbestimmten zulässigen Bereich eines Versatzes, der vorgesehen ist, um irgendwelche Beeinträchtigung mit anderen bereits auf dem Schaltungssubstrat montierten Komponenten zu vermeiden;
      Korrigieren der Position der Komponente (3) basierend auf dem Versatz und Montieren der Komponente (3) an der Montageposition des Schaltungssubstrats (21), falls der Versatz zwischen der Komponente (3) und dem Komponentenhalter (14) innerhalb des zulässigen Bereichs des Versatzes liegt, und
      Freigeben der Komponente (3) an einer Freigabestation (22) anstelle des Montierens der Komponente auf dem Schaltungssubstrat (21), falls der Versatz zwischen der Komponente (3) und dem Komponentenhalter (14) außerhalb des zulässigen Bereichs des Versatzes liegt,
wobei die Bewegungsgeschwindigkeit des Komponentenhalters (14) herabgesetzt wird, bis er die Freigabestation (22) zum Freigeben der Komponente (3) erreicht, falls in dem Erkennungsschritt des Haltezustands der Komponente bestimmt wird, dass die Komponente (3) in einem zum Montieren falschen Zustand gehalten wird.

3. Vorrichtung zum Montieren von Komponenten, die aufweist:

eine Zuführeinrichtung (7) zum Zuführen von Komponenten (3) an eine Komponentenzuführung (2),
einen Platzierkopf (12) zum Aufnehmen der Komponente (3) von der Komponentenzuführung (2) und zum Montieren der Komponente (3) auf einem fest positionierten Schaltungssubstrat (21),
eine Detektoranordnung (17, 19) zum Erkennen des Haltezustands der durch den am Komponentenplatzierkopf (12) befestigten Komponentenhalter (14) gehaltenen Komponente (3),
einen Sammelbehälter (23) zum Sammeln von Komponenten (3), falls durch die Detektoranordnung (17, 19) erkannt wurde, dass die Komponenten (3) für das Montieren im falschen Zustand gehalten werden, und
eine Transfervorrichtung (11) zum Transferieren des Platzierkopfes (12) mindestens an Stationen (15) zum Aufnehmen von Komponenten, Stationen (16) zum Erkennen von Komponentenhaltezuständen, Stationen (20) zum Montieren der Komponenten (3) auf dem Schaltungssubstrat und Stationen (22) zum Sammeln von Komponenten,
wobei die Vorrichtung zum Montieren von Komponenten eine Steuerung aufweist, welche die Bewegungsgeschwindigkeit des mit dem Komponentenhalter (12) ausgestatteten Platzierkopfes (12) herabsetzt bis der Komponentenhalter die Komponente (3), die in einem für das Montieren falschen Zustand gehalten wird, in den Sammelbehälter (23) freigibt.

4. Vorrichtung zum Montieren von Komponenten nach Anspruch 3, wobei die Transfervorrichtung (11) ein Magazin (11) aufweist, welches eine Vielzahl von um das Magazin (11) umlaufenden Aufnahmeköpfen (12) aufweist, und welches diese mit Unterbrechung rotieren lässt.

5. Vorrichtung zum Montieren von Komponenten nach einem der Ansprüche 3 oder 4, wobei der Komponentenhalter (14) eine Düse zum Halten der Komponente (3) durch Ansaugen dieser durch ein Vakuum aufweist.

6. Vorrichtung zum Montieren von Komponenten nach Anspruch 5, wobei die Vorrichtung zum Montieren von Komponenten eine Steuerung aufweist, welche die Düse (14) oder den Komponentenhalter zum Ausblasen von Druckluft von der Düsenöffnung steuert, nachdem die Düse (14) die Komponente (3) freigegeben hat, die in einem für das Montieren falschen Zustand gehalten wird, und bevor die Düse (14) eine neue Komponente (3) aufnimmt, oder wenn Rückstände an der Düse gefunden werden.

7. Vorrichtung zum Montieren von Komponenten nach Anspruch 6, wobei die Vorrichtung zum Montieren von Komponenten eine Steuerung zum Steuern der Fertigungsschritte derart aufweist, um einen Feststellungsschritt durchzuführen, ob irgendwelche Rückstände an der Düse (14) vorhanden sind, nachdem die Düse (14) Druckluft ausgeblasen hat und bevor die Düse (14) eine neue Komponente (3) aufnimmt.

## Revendications

1. Procédé de montage de composants réalisant une série d’opérations de production comportant les étapes qui consistent :

à prélever un composant (3) fourni à une alimentation (2) de composants par un porte composants (14) ;
à détecter une condition de support du composant (3) maintenu par le porte composants (14) ;
à monter le composant (3) sur une position de montage d’un substrat (21) de circuit par le porte composants (14) si on détermine à ladite étape de détection que le composant (3) est maintenu dans une condition correcte pour le montage, et
à libérer le composant (3) au niveau d’une station de libération (22) au lieu de le monter si on détermine à ladite étape de détection que le composant (3) est maintenu dans une condition non correcte pour le montage, et à prélever ensuite un nouveau composant (3) par le porte composants (14),
ou, si une valeur de déplacement entre le composant (3) et le porte composants (14) se trouve en dehors d’une plage admissible prédéterminée préparée pour éviter toute interférence avec d’autres composants déjà montés sur le substrat de circuit, on détermine que le composant (3) est maintenu dans une condition non correcte pour le montage, et
ou la vitesse de déplacement du porte composants (14) jusqu'à ce qu'il atteigne la station de libération (22) pour libérer le composant (3) est réduite, si on détermine à ladite étape de détection d'une condition de support de composants que le composant (3) est maintenu dans une condition non correcte pour le montage.

**2.** Procédé de montage de composants réalisant une série d'opérations de production comportant les étapes qui consistent :

à prélever un composant (3) fourni à une alimentation (2) de composants par un porte composants (14) ;
à détecter une condition de support du composant (3) maintenu par le porte composants (14) ;
à monter le composant (3) sur une position de montage d'un substrat (21) de circuit par le porte composants (14) si on détermine à ladite étape de détection que le composant (3) est maintenu dans une condition correcte pour le montage, et
à libérer le composant (3) au niveau d'une station de libération (22) au lieu de le monter si on détermine à ladite étape de détection que le composant (3) est maintenu dans une condition non correcte pour le montage, et à prélever ensuite un nouveau composant (3) par le porte composants (14),
où le procédé comporte en outre les étapes qui consistent :

à comparer une valeur de déplacement entre le composant (3) et le porte composants (14) avec une plage de déplacement admissible prédéterminée préparée pour éviter toute interférence avec d'autres composants déjà montés sur le substrat de circuit, avant de détecter une condition de maintien du composant (3) ;
à corriger la position du composant (3) sur la base du déplacement, et à monter le composant (3) sur la position de montage du substrat (21) de circuit si le déplacement entre le composant (3) et le porte composants (14) se trouve dans ladite plage admissible de déplacement, et
à libérer le composant (3) au niveau de la station de libération (22), au lieu de monter le composant sur le substrat (21) de circuit, si le déplacement entre le composant (3) et le porte composants (14) est en dehors de la plage admissible de déplacement,
où la vitesse de déplacement du porte composants (14) jusqu'à ce qu'il atteigne la station de libération (22) pour libérer le composant (3) est réduite, si on détermine à ladite étape de détection d'une condition de maintien de composants que le composant (3) est maintenu dans une condition non correcte pour le montage.

**3.** Appareil de montage de composants comprenant :

un dispositif d'alimentation (7) destiné à fournir des composants (3) à une alimentation (2) de composants ;
une tête de placement (12) destinée à prélever le composant (3) à partir de l'alimentation (2) de composants, et monter le composant (3) sur un substrat (21) de circuit qui est positionné et fermement maintenu ;
un dispositif de détection (17, 19) destiné à détecter une condition de maintien du composant (3) maintenu par un porte composants (14) fixé à la tête de placement (12) de composant ;
une boîte collectrice (23) destinée à collecter des composants (3) si on détermine par le dispositif de détection (17, 19) que les composants (3) sont maintenus dans une condition non correcte pour le montage, et
un dispositif de transfert (11) destiné à transférer la tête de placement (12) à au moins des stations de prélèvement de composants (15), à détecter une condition de maintien (16) de composants, à monter le composant (3) sur le substrat (20) de circuit, et à collecter des composants (22),
où l'appareil de montage de composants a une unité de commande qui réduit la vitesse de déplacement de la tête de placement (12) équipée du porte composants (14) jusqu'à ce que le porte composants libère le composant (3) maintenu dans une condition non correcte pour le montage dans la boîte collectrice (23).

**4.** Appareil de montage de composants selon la revendication 3, dans lequel le dispositif de transfert (11) comprend un index (11) ayant une pluralité de têtes de placement (12) de manière circonférentielle autour de l'index (11), et les faire tourner de manière intermittente.

**5.** Appareil de montage de composants selon les revendications 3 ou 4, dans lequel le porte composants (14) comprend une buse destinée à maintenir le composant (3) en l'aspirant sous vide.

**6.** Appareil de montage de composants selon la revendication 5, dans lequel l'appareil de montage de composants a une unité de commande qui commande la buse (14), ou le porte composants, pour souffler l'air comprimé de l'ouverture de la buse après libération par la buse (14) du composant (3) maintenu dans une condition non correcte pour le montage et avant que la buse (14) ne prélève un nouveau composant (3), ou lorsqu'on trouve des débris au niveau de la buse.

**7.** Appareil de montage de composants selon la revendication 6, dans lequel l'appareil de montage de composants a une unité de commande destinée à commander les opérations de production de sorte à réaliser une opération de confirmation si tout débris existe au niveau de la buse (14) après que la buse (14) souffle l'air comprimé, et avant que la buse (14) ne prélève un nouveau composant (3).

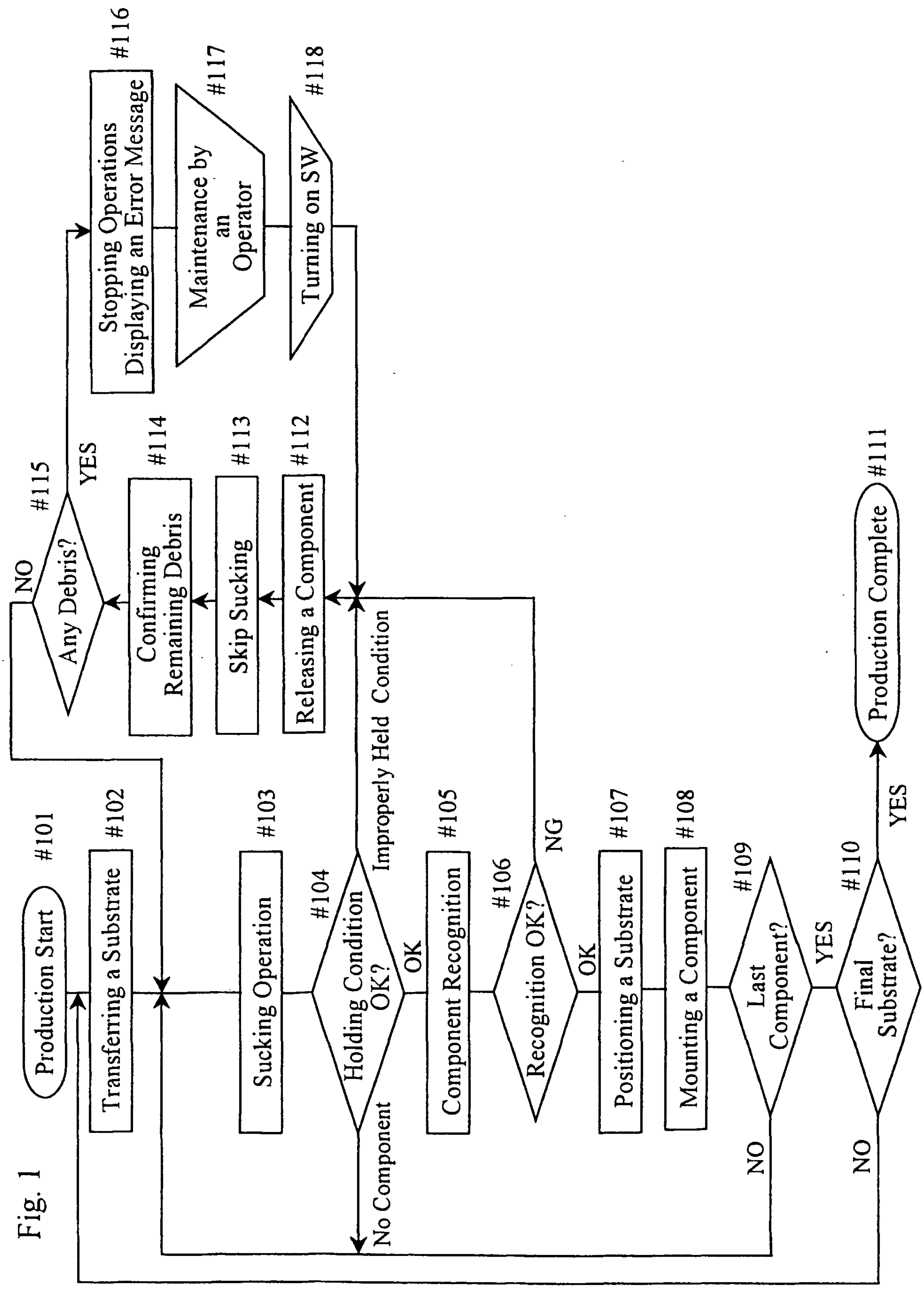
Production Start
#101
Transferring a Substrate
#102
Sucking Operation
#103
Holding Condition OK?
#104
OK
No Component
Improperly Held Condition
Component Recognition
#105
Recognition OK?
#106
OK
NG
Positioning a Substrate
#107
Mounting a Component
#108
Last Component?
#109
YES
NO
Final Substrate?
#110
YES
NO
Production Complete
#111
Releasing a Component
#112
Skip Sucking
#113
Confirming Remaining Debris
#114
Any Debris?
#115
NO
YES
Stopping Operations Displaying an Error Message
#116
Maintenance by an Operator
#117
Turning on SW
#118

Fig. 1

Fig. 2

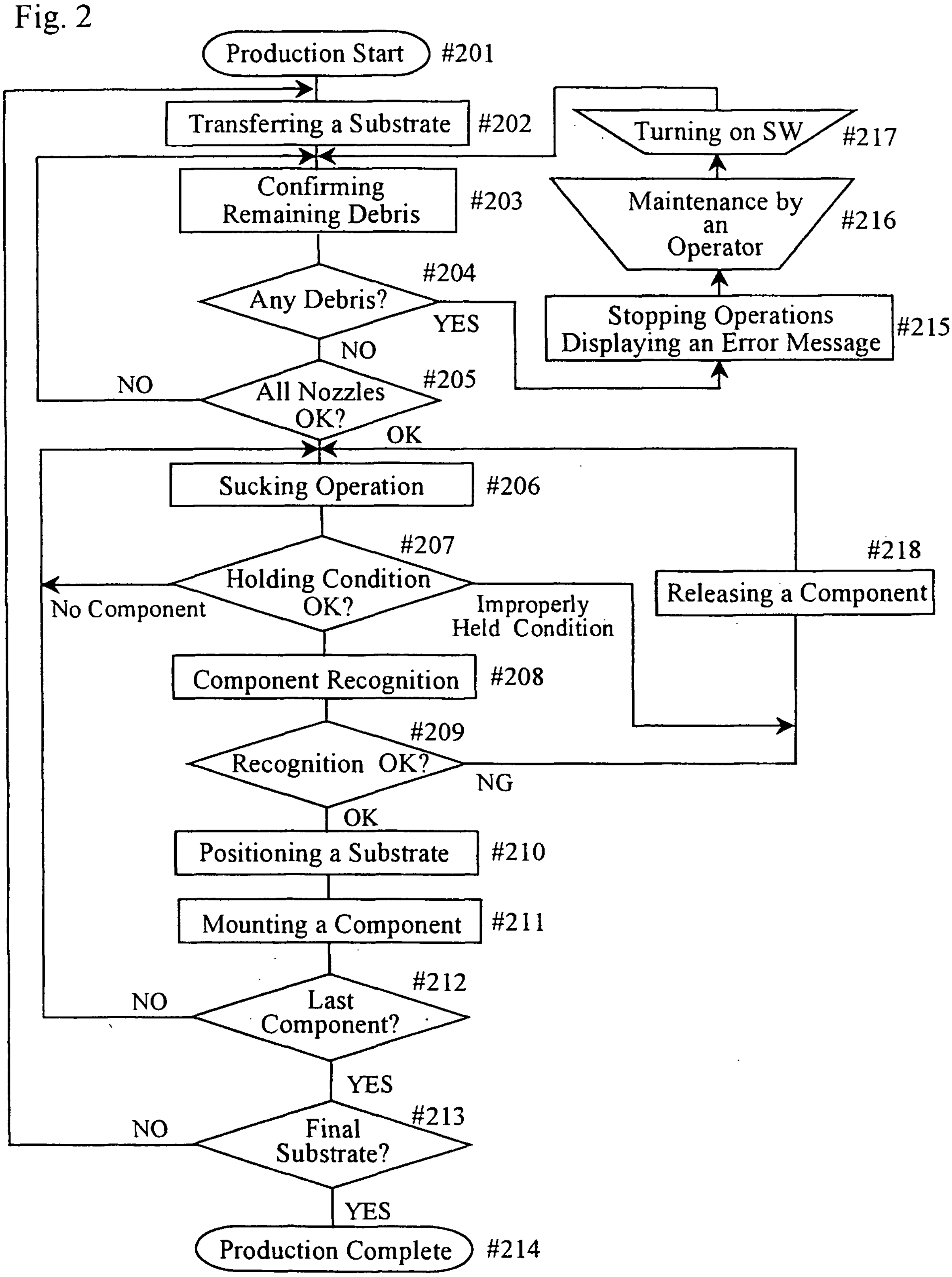
Production Start
#201
Transferring a Substrate
#202
Confirming Remaining Debris
#203
Any Debris?
#204
YES
NO
All Nozzles OK?
#205
NO
OK
Turning on SW
#217
Maintenance by an Operator
#216
Stopping Operations Displaying an Error Message
#215
Sucking Operation
#206
Holding Condition OK?
#207
No Component
Improperly Held Condition
Releasing a Component
#218
Component Recognition
#208
Recognition OK?
#209
NG
OK
Positioning a Substrate
#210
Mounting a Component
#211
Last Component?
#212
NO
YES
Final Substrate?
#213
NO
YES
Production Complete
#214

Fig. 3

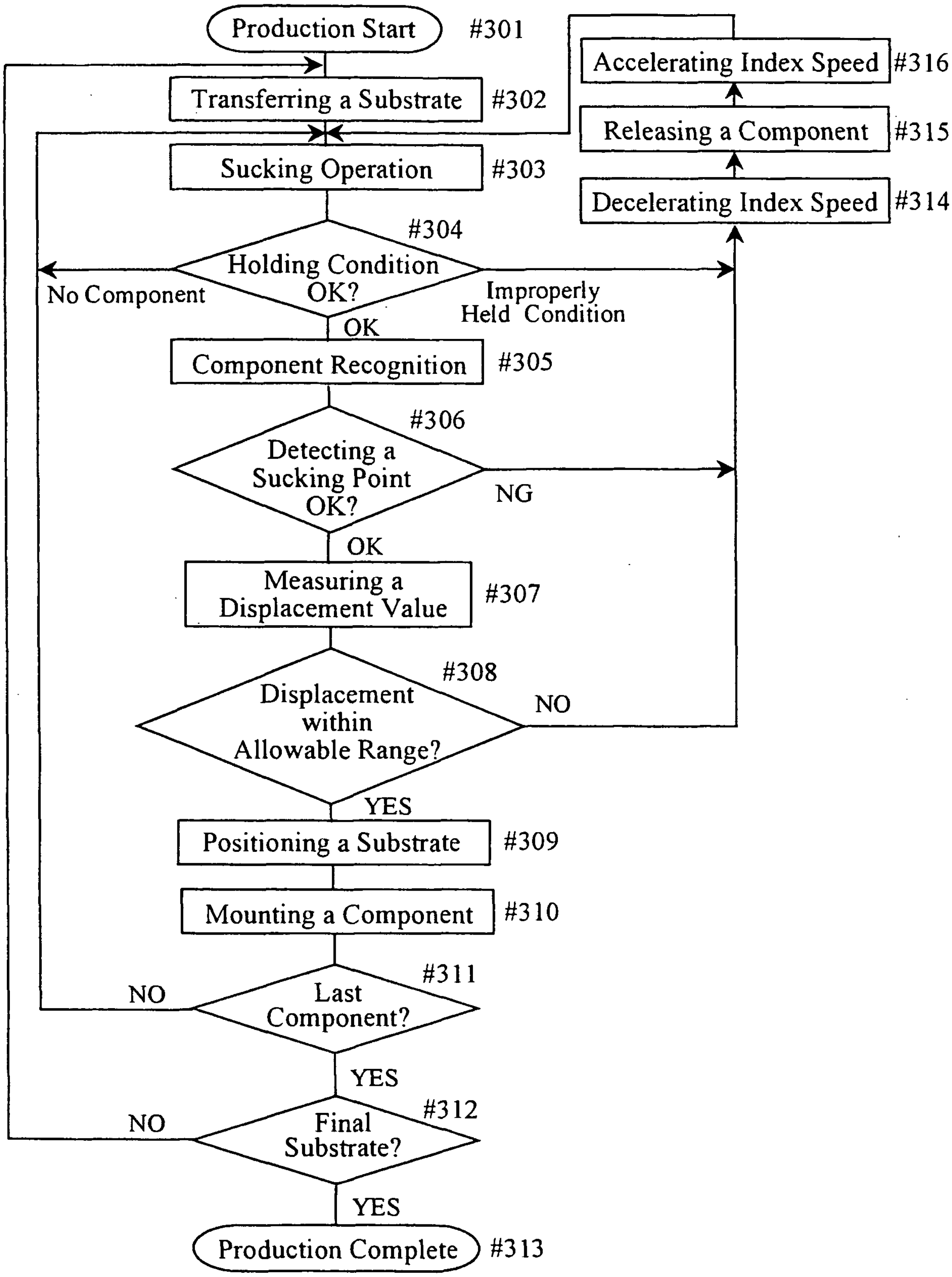
Production Start
#301
Transferring a Substrate
#302
Sucking Operation
#303
#304
Holding Condition OK?
No Component
OK
Improperly Held Condition
Component Recognition
#305
#306
Detecting a Sucking Point OK?
NG
OK
Measuring a Displacement Value
#307
#308
Displacement within Allowable Range?
NO
YES
Positioning a Substrate
#309
Mounting a Component
#310
#311
Last Component?
NO
YES
#312
Final Substrate?
NO
YES
Production Complete
#313
Accelerating Index Speed
#316
Releasing a Component
#315
Decelerating Index Speed
#314

Fig. 4

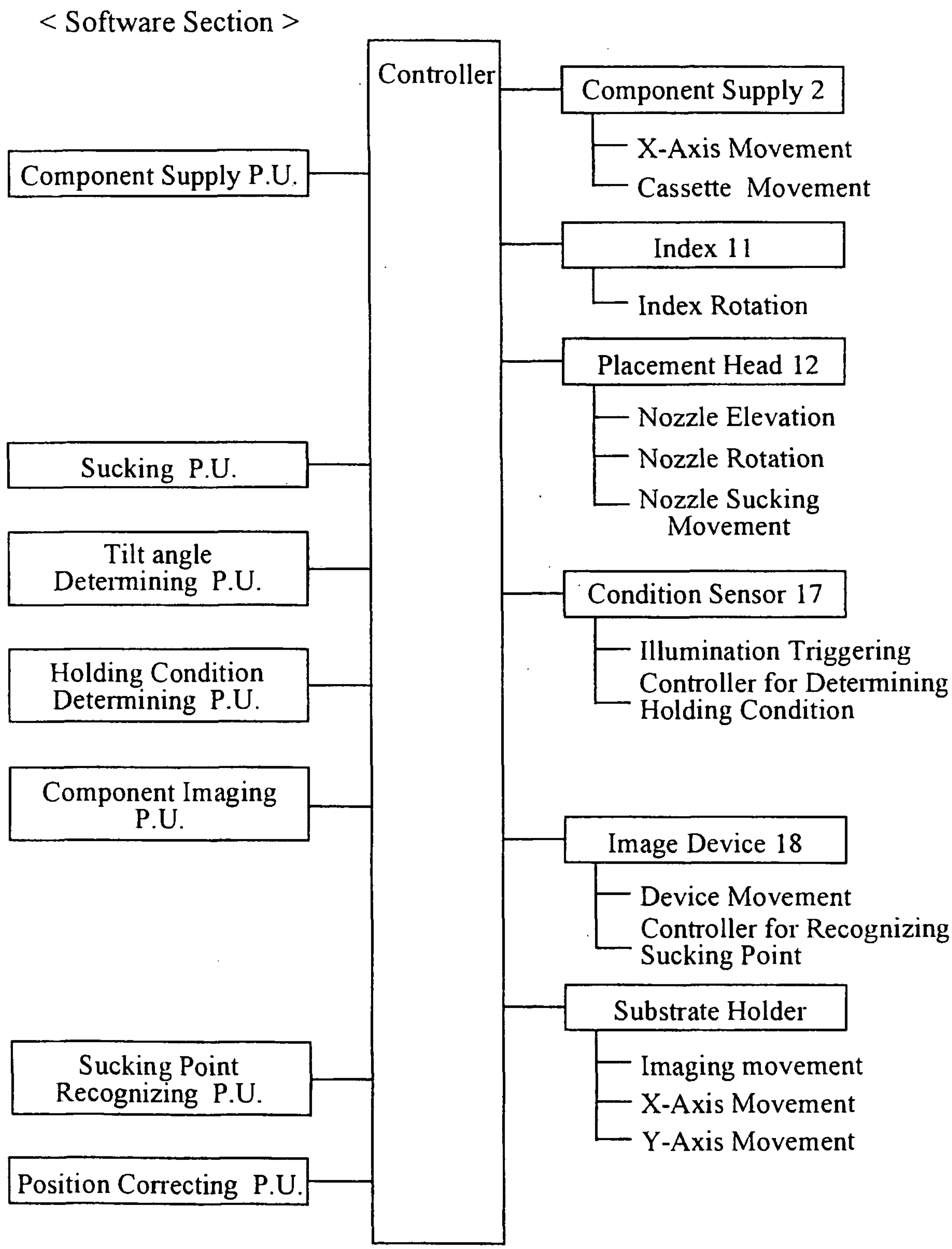
< Software Section >
Controller
Component Supply 2
X-Axis Movement
Cassette Movement
Component Supply P.U.
Index 11
Index Rotation
Placement Head 12
Nozzle Elevation
Nozzle Rotation
Nozzle Sucking Movement
Sucking P.U.
Tilt angle Determining P.U.
Condition Sensor 17
Illumination Triggering
Controller for Determining Holding Condition
Holding Condition Determining P.U.
Component Imaging P.U.
Image Device 18
Device Movement
Controller for Recognizing Sucking Point
Substrate Holder
Imaging movement
X-Axis Movement
Y-Axis Movement
Sucking Point Recognizing P.U.
Position Correcting P.U.

Fig. 5

Prior Art

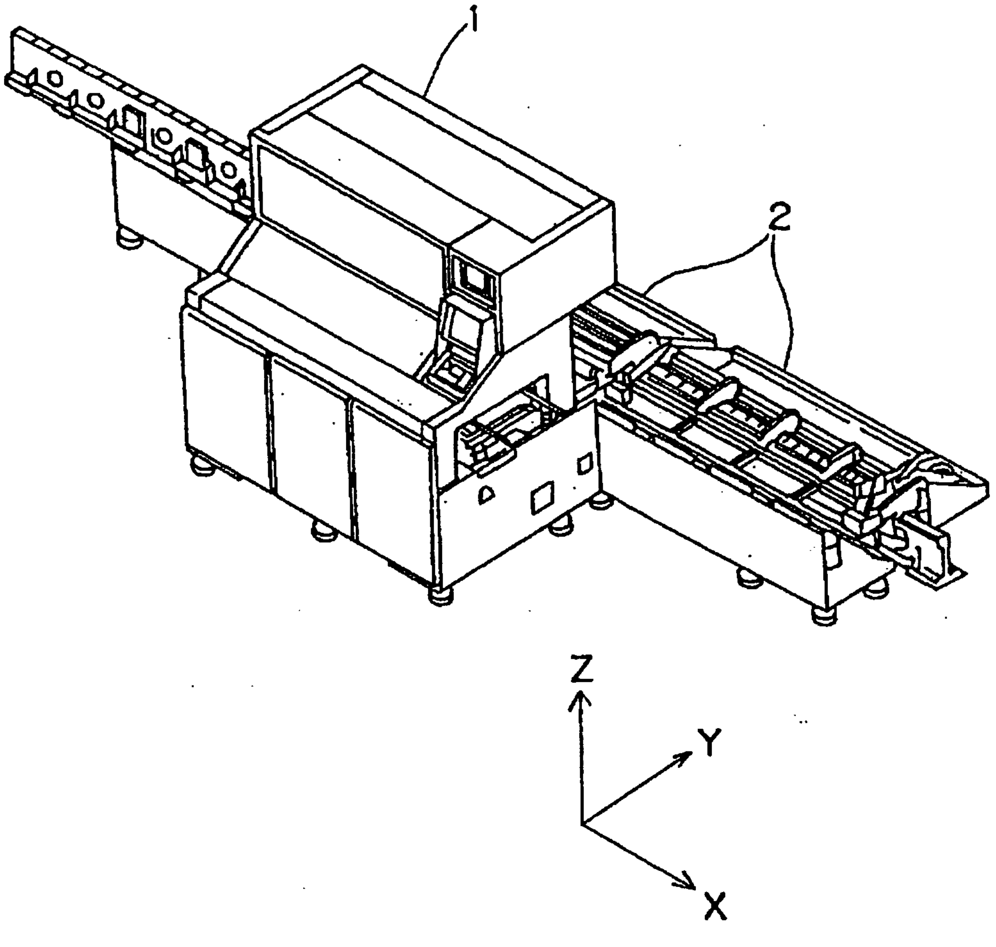

Fig. 6 (A)

Prior Art

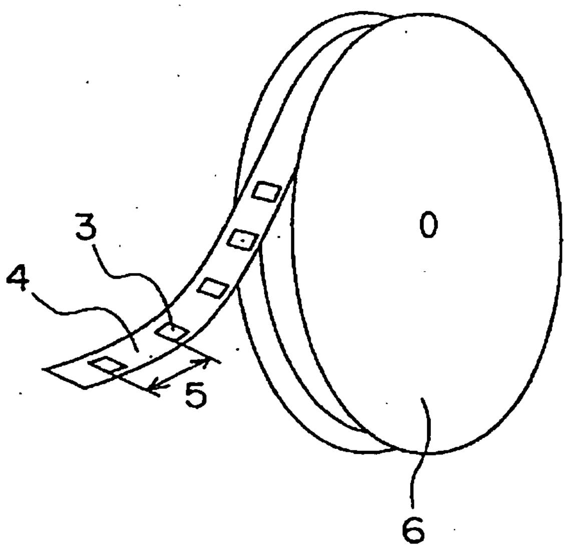


Fig. 6 (B)

Prior Art

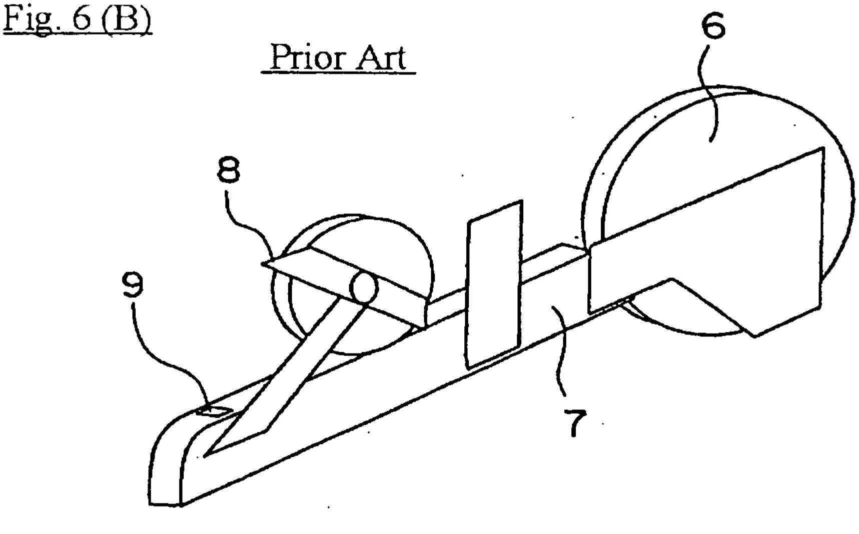

Fig. 7

Prior Art

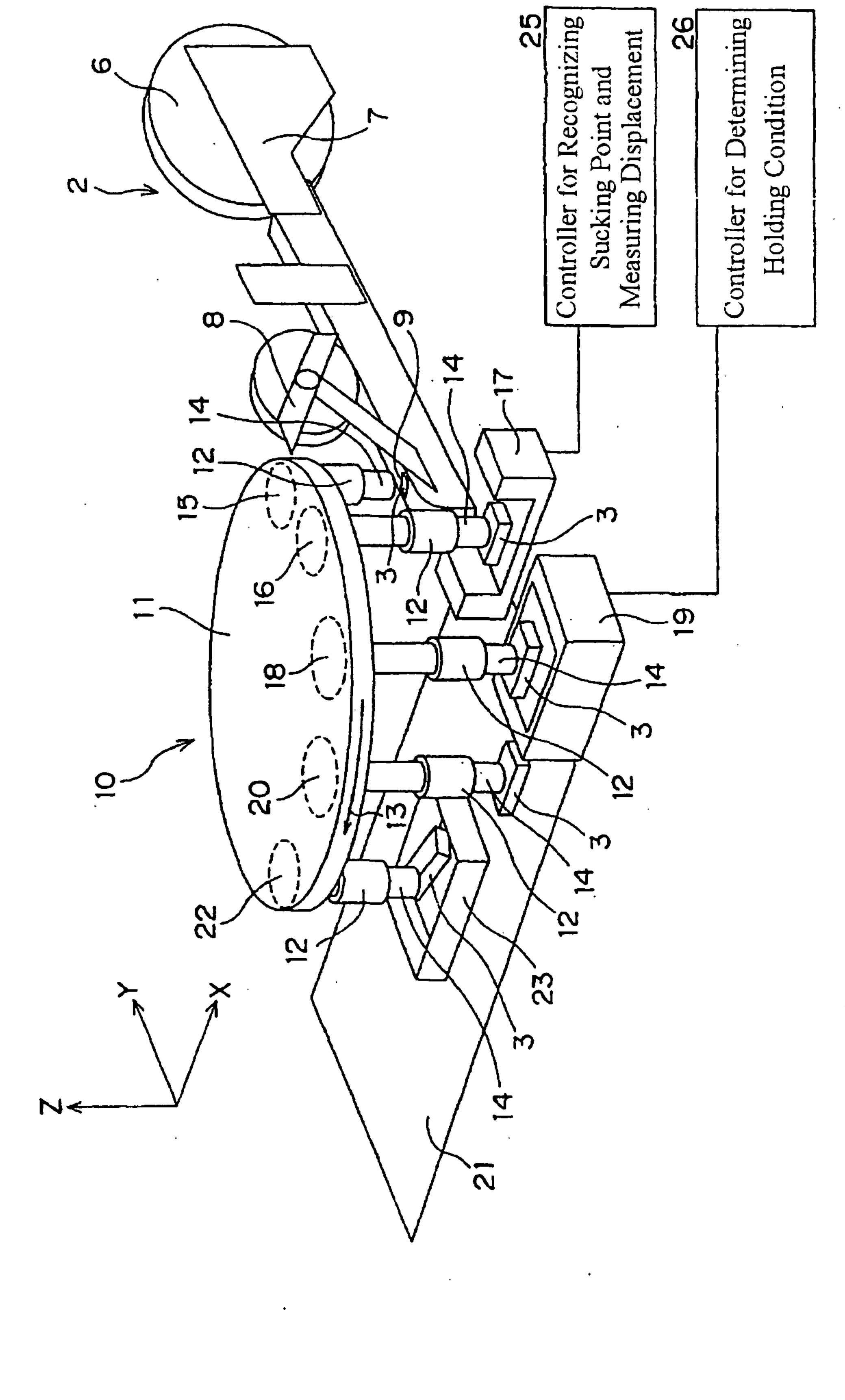

Fig. 8

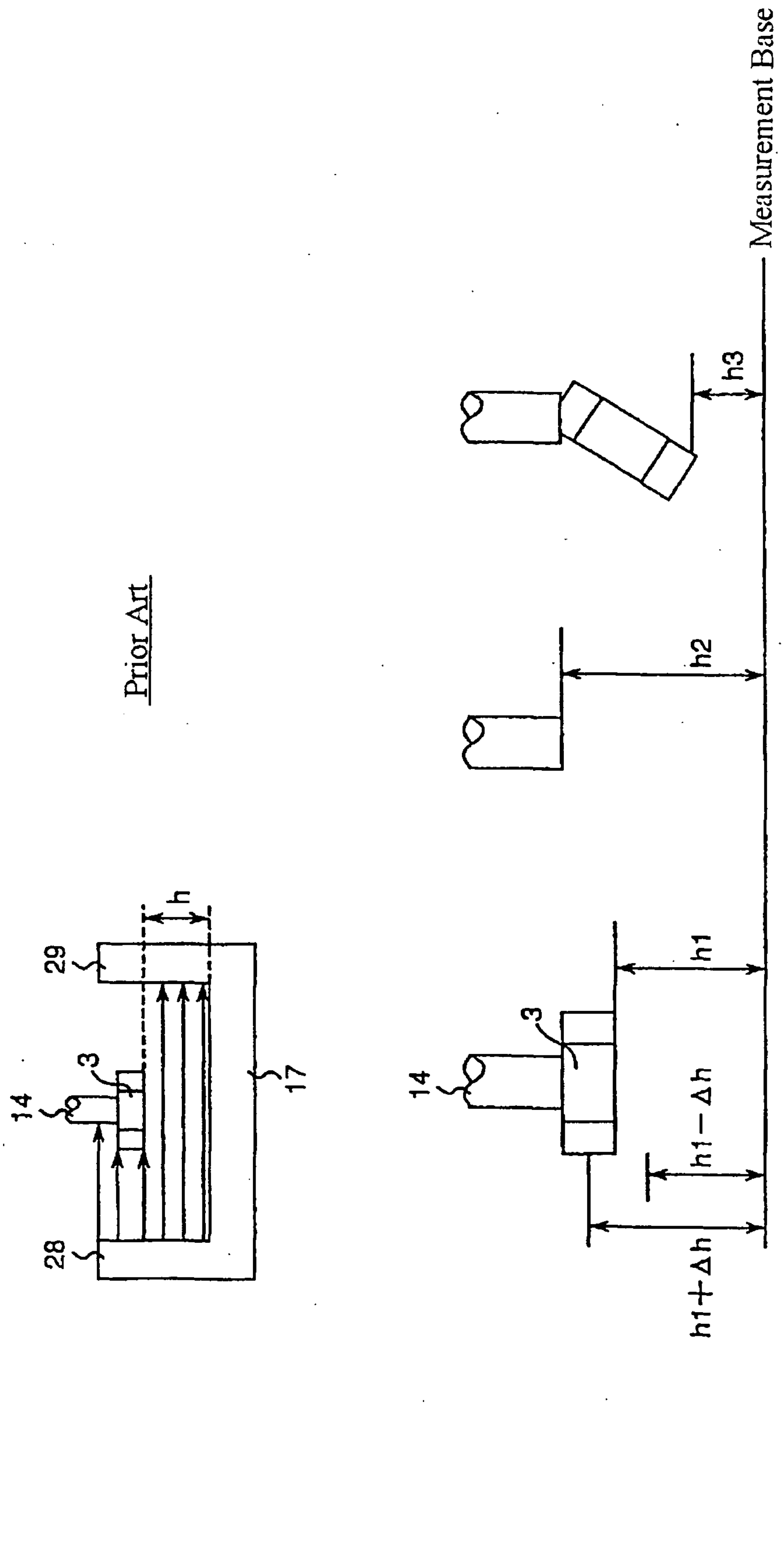

Fig. 9

Prior Art

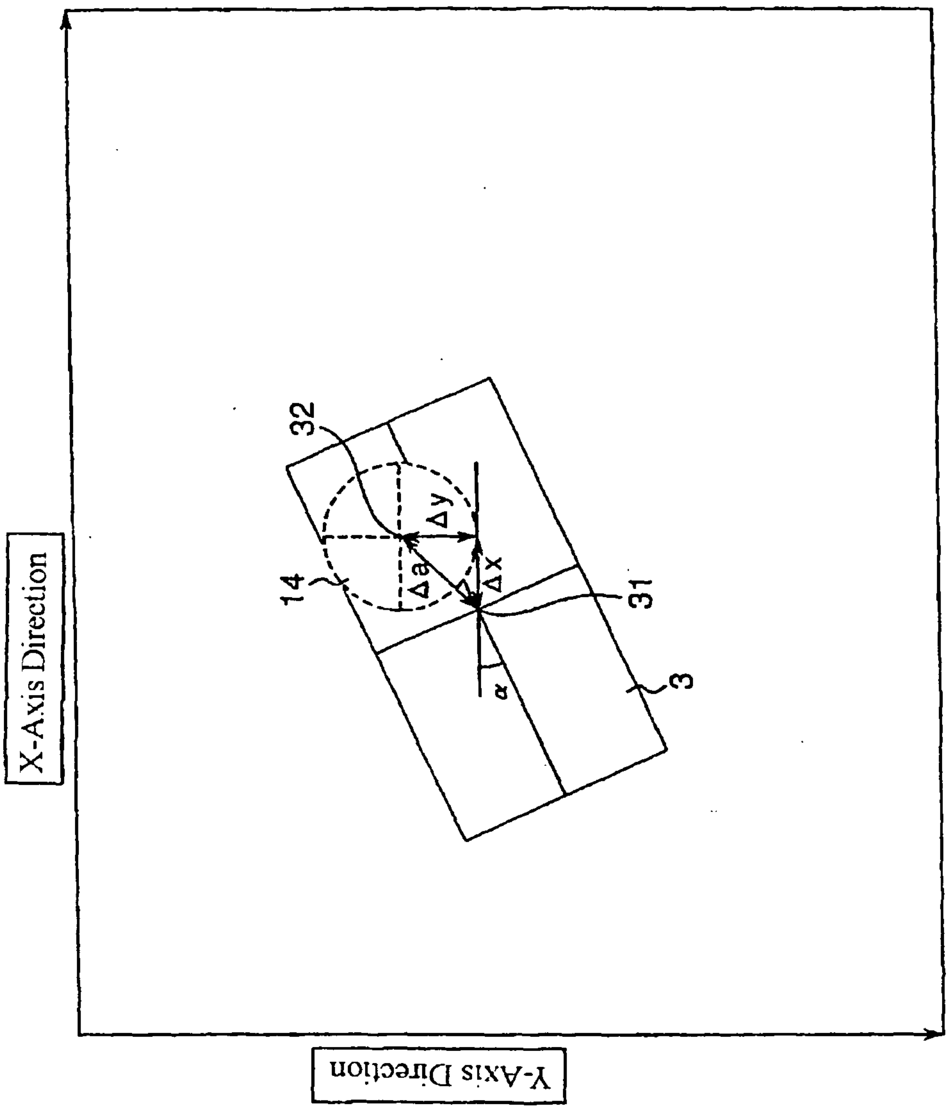

Fig. 10

< Prior Art >

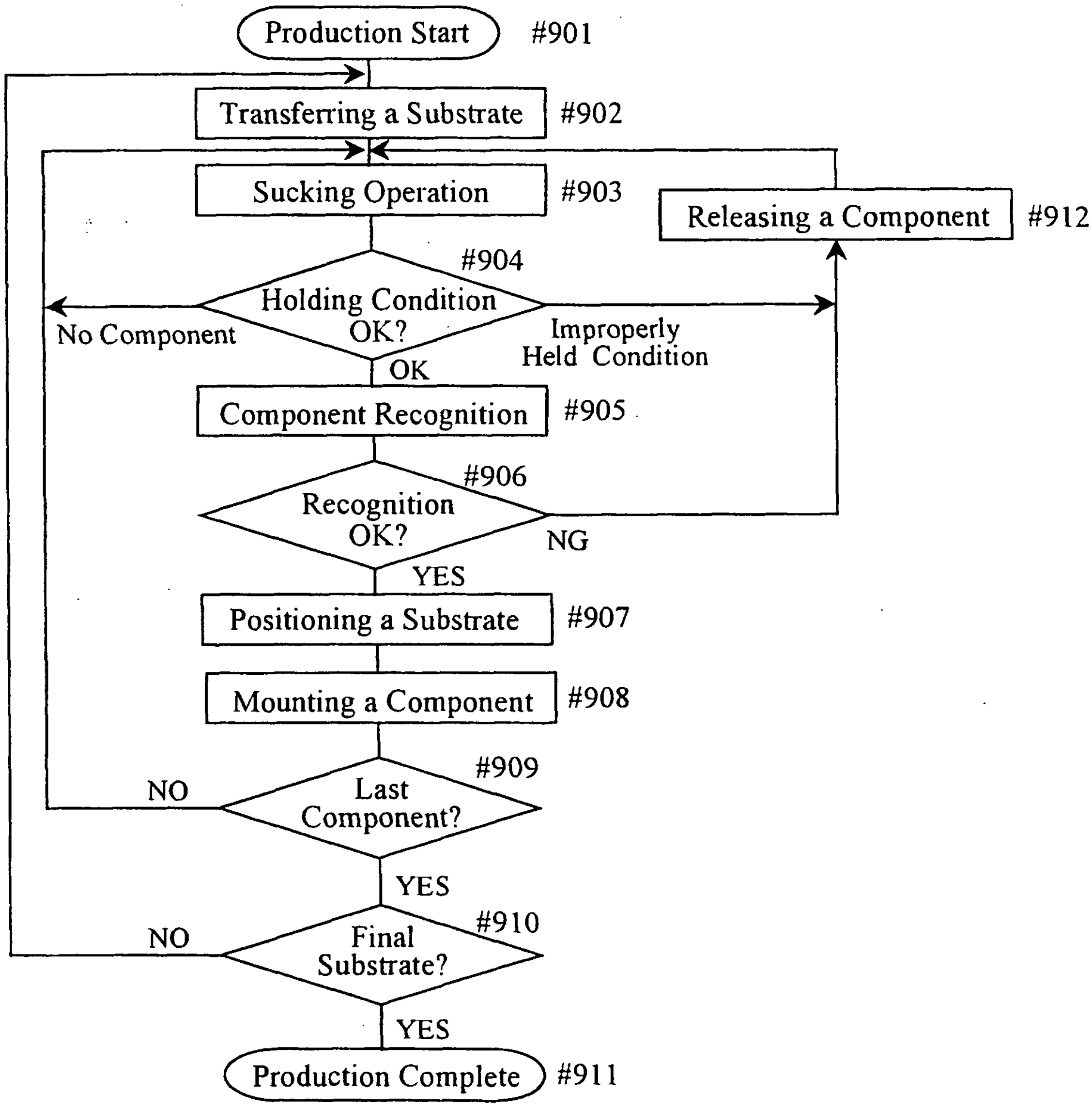

Fig. 11 (A)

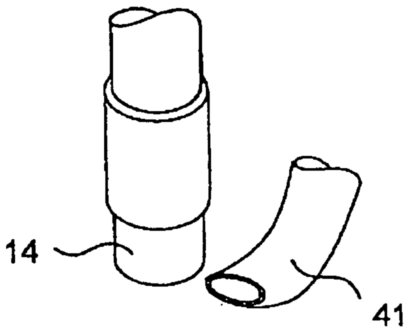


Fig. 11 (B)

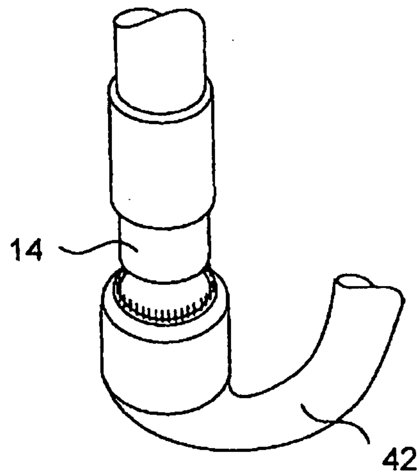


Fig. 11 (C)